(19) Europäisches Patentamt
European Patent Office
Office européen des brevets

(11) Publication number: **0 036 620**
**B1**

(12) **EUROPEAN PATENT SPECIFICATION**

(45) Date of publication of patent specification: **21.09.83**

(21) Application number: **81101993.4**

(22) Date of filing: **17.03.81**

(51) Int. Cl.$^3$: **H 01 L 21/306,**
H 01 L 21/203,
H 01 L 21/90

(54) **Semiconductor device and method for fabricating the same.**

(30) Priority: **22.03.80 JP 35775/80**
**23.12.80 JP 182336/80**

(43) Date of publication of application:
**30.09.81 Bulletin 81/39**

(45) Publication of the grant of the patent:
**21.09.83 Bulletin 83/38**

(84) Designated Contracting States:
**DE FR GB NL**

(56) References cited:
**EP - A - 0 004 292**
**US - A - 3 738 880**
**US - A - 4 148 055**

**IBM TECHNICAL DISCLOSURE BULLETIN, Vol. 16, No. 10, March 1974 New York HUTCHINS et al. "Fabricating Isolated Device-Quality Semiconductor Film Areas on a Foreign Substrate using Laser Melting" pages 3488, 3489**
**IBM TECHNICAL DISCLOSURE BULLETIN, Vol. 14, No. 7, December 1971 New York JADUS et al. "Simultaneous Polycrystalline and Monocrystalline Epitaxial Silicon Growth" page 2100**

(73) Proprietor: **TOKYO SHIBAURA DENKI KABUSHIKI KAISHA**
**72, Horikawa-cho Saiwai-ku**
**Kawasaki-shi Kanagawa-ken 210 (JP)**

(72) Inventor: **Sasaki, Yoshitaka**
**241-2, Sanmai-cho**
**Kanagawa-ku Yokohama-shi (JP)**

(74) Representative: **Patentanwälte Henkel, Pfenning, Feiler, Hänzel & Meinig**
**Möhlstrasse 37**
**D-8000 München 80 (DE)**

(56) References cited:
**IEDM TECHNICAL DIGEST, December 1979 New York TANG et al. "Sub-Nanosecond Self-Aligned I2L/MTL Circuits" pages 201 to 204**
**IEEE JOURNAL OF SOLID-STATE CIRCUITS, Vol. SC-14, No. 5, October 1979 New York DAVIES et al. "Considerations for High-Speed and Analog-Circuit-Compatible I2L and the Analysis of Poly I2L" pages 876 to 887**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**EP 0 036 620 B1**

# Semiconductor device and method for fabricating the same

The present invention relates to a semiconductor device and a method for fabricating the same.

A bipolar transistor suitable for use within the high frequency range or suitable as a high speed switching element is required to have a great gain band product. In order to increase the gain band product of the bipolar transistor, it is necessary to make the element size smaller and especially to reduce the base transit time of the minority carriers. Most of the silicon transistors which are currently used are of the planar type, and their emitters and bases are formed by impurity diffusion. In such a case, when the dimension of the emitter is small, the junction plane of the emitter and the base becomes curved, and the effective base transit time depends not only on the base width but also on the collector-base junction depth. Accordingly, for improving the gain band product of the bipolar transistor, it is necessary to reduce the base width as well as the collector-base junction depth. Thus, the problem is to how to realize a shallow diffusion junction.

A conventional bipolar npn transistor is of the structure shown in Fig. 1. On a $p^-$-type silicon substrate 1 are formed an $n^+$-type buried layer 2 and an n-type epitaxial layer 3. A $p^+$-type isolation region 4 for element isolation is formed in the epitaxial layer 3. A p-type base region 5 is formed at the part of the island epitaxial layer 3 isolated by the isolation region 4, and an $n^+$-type emitter region 6 is formed in the base region 5. A diffusion layer 7 reaching to the $n^+$-type buried layer 2 for connection with the collector is formed in another part of the epitaxial layer 3. An oxide film 8 is formed on the n-type epitaxial layer 3 by thermal oxidation. Aluminum electrodes 10, 11 and 12 for connection with the emitter region 6, the base region 5, and the diffusion layer 7 for connection with the collector are formed thereover through contact holes 9a, 9b and 9c, respectively.

In a bipolar transistor of such a structure, when the depth of the base region 5 is made small, the base resistance increases accordingly. Especially when the base region 5 becomes extremely shallow, the base resistance depends on the distance l between the emitter side end of the base contact hole 9b and the emitter region 6. This distance l is determined by the relative positions of the diffusion windows for the emitter region 6 and the base contact holes. This relation is in turn determined by the photoetching technique. With the current photoetching technique, it is difficult to make the distance l less than 2 $\mu$m. This places a limit on the reduction of the base resistance.

Taking an $I^2L$ (Integrated Injection Logic) element which is a bipolar logic element as an example, a conventional $I^2L$ is of the structure shown in Fig. 2. In the $p^-$-type silicon substrate 1 are formed the $n^+$-type buried layer 2 and the n-type epitaxial layer 3. The epitaxial layer 3 is isolated by the $p^+$-type isolation region 4. A p-type injector 13 and a p-type base region 14 are formed in the epitaxial layer 3. A plurality of $n^+$-type collector regions 15a, 15b are formed in the base region 14. The oxide film 8 is formed on the epitaxial layer 3 by thermal oxidation.

On the oxide film 8 are formed through the contact holes 9 the collector regions 15a, 15b, the base region 14, the injector 13, and aluminum electrodes 16a, 16b, 17, 18, and 19 connected with an extension 2′ of the $n^+$-type buried layer 2.

An $I^2L$ of such a structure is a bipolar logic element of a composite structure incorporating a vertical npn transistor of the reverse operation type wherein the emitter and the collector of a normal transistor are reversed, and a lateral pnp transistor using the base of the vertical npn transistor as the collector. With such an $I^2L$, since the vertical npn transistor as the inverter is inverted, the emitter-base junction area is vastly greater than the collector-base junction area so that a sufficiently high speed operation of the bipolar element may not be attained. Thus, since carrier injection into the base region is performed from the entire emitter region surrounding the part immediately below the collector region, the effective base width becomes great, the current amplification factor becomes small, and the gain band product becomes small. As a result, the performance of the $I^2L$ is degraded, and especially the switching speed is suppressed.

An $I^2L$ which is free of such defects is described in IEDM Technical Digest (1979), pp. 201 to 204, "Sub-Nanosecond Self-Aligned $I^2L$/MTL Circuits". A polycrystalline silicon layer in which is doped an $n^+$-type impurity to a high concentration is used as the collector region in this $I^2L$. The base contact holes and the collector region are formed by the self-aligning technique utilizing the thickness difference with the silicon oxide film. The base region exposed at the surface of the substrate is covered with a metal to decrease the base resistance, allowing a structure such that the ratio of the emitter-base junction area to the collector-base junction area may approach 1.

This $I^2L$ shows the best performance of 0.8 nsec in minimum propagation delay time among the conventional $I^2L$s. However, this $I^2L$ also has many problems. The method for fabricating this element will be described in detail with reference to the attached drawings.

First, an n-type epitaxial layer 23 is formed in an $n^+$-type semiconductor substrate 22a. A high-concentration $n^+$-type semiconductor film 22b is formed at the surface of the substrate 22a to provide the emitter region (Fig. 3A).

Next, a silicon nitride layer 24 is deposited to a thickness of 100 nm, as shown in Fig. 3B. After removing desired parts of the silicon nitride layer, the n-type epitaxial layer 23 thereunder is selectively etched. A heat treatment is performed to form a silicon oxide layer 25 of about 1.0 to 1.5 μm thickness on the etched part. Since this silicon oxide layer 25 is formed to surround the periphery of the I²L gate, it is also called the oxide film collar or the oxide isolation layer. This silicon oxide layer functions to isolate between the gates of the I²L and to improve the injection efficiency of the minority carriers injected from the emitter to the base. After removing all of the silicon nitride layer 24, a silicon oxide layer is again formed to a thickness of 500 nm. By opening a desired part of the silicon oxide layer, a silicon oxide layer 26 is formed (Fig. 3C).

After forming a base region 27 and an injector region 28, an arsenic-doped polycrystalline silicon film 29 is deposited to a thickness of 300 nm, and a CVD silicon oxide layer (CVD-$SiO_2$) 30 is deposited thereover to a thickness of 300 nm. The CVD-$SiO_2$ is patterned by the photoetching technique. Using the CVD-$SiO_2$ pattern 30 as a mask, the arsenic-doped polycrystalline silicon film is etched with a solution of a mixture of $HF:HNO_3:CH_3COOH=1:3:8$ (Fig. 3D). The selectively left portion of the arsenic-doped polycrystalline silicon film 29 exists on the base region 27 for forming the collector region of the I²L, and is used for connection with the collector electrode.

After forming a collector region 31 by diffusion using the arsenic-doped polycrystalline silicon film 29 as a diffusion source, the structure is thermally oxidized at a low temperature (700 to 900°C). At this time, a silicon oxide film 32b of about several ten nm thickness is formed on the base region 27 and the injector region 28, and a silicon oxide film 32a of about 100 to 200 nm thickness is formed on the side surface of the arsenic-doped polycrystalline silicon film 29. This is because the growing speed of the high-concentration $n^+$-type semiconductor layer is greater by a factor of several to several tens than that of the low-concentration $n^+$-type semiconductor layer when oxidized at a low temperature (700 to 900°C). Next, for reducing the contact resistance with metal electrode layer, ion implantation of high-concentration $p^+$-type ions is performed to form the injector region 28 and an outer base region 27' by diffusion (Fig. 3E).

Then, the silicon oxide film 32b on the injector region 28 and the outer base region 27' is etched by the self-aligning technique. All the contact holes are opened by the photoetching technique. After coating a metal electrode layer, electrode isolation is performed to form a base-connecting electrode 33, an injector-connecting electrode 34, and an emitter-grounding electrode 35 to provide an I²L (Fig. 3F). Fig. 4 shows a plan view of Fig. 3F, and Fig. 5 shows a sectional view along the line V—V of Fig. 4.

With an I²L fabricated by the above process, the electrodes of the base, the injector, and the emitter may be formed from the metal electrode layer, and the collector electrode may be formed from the arsenic-doped polycrystalline silicon layer, providing the various advantages described above. However, this method of fabricating an I²L has various problems to be described below.

In the process shown in Fig. 3D, when etching the arsenic-doped polycrystalline silicon film using the CVD-$SiO_2$ film pattern 30 as a mask, isotropic etching using a mixture of HF, $HNO_3$, and $CH_3COOH$ as a liquid etchant is used. Accordingly, the polycrystalline film is side etched to a depth corresponding to its film thickness, so that the CVD-$SiO_2$ film 30 overhangs. When the arsenic-doped polycrystalline silicon film 29 is oxidized under such conditions, the silicon oxide film 32a grows in an anomalous form at the circumferential surface of the arsenic-doped polycrystalline silicon film 29, moving the underlying CVD-$SiO_2$ pattern 30 upward. This disadvantageously tends to cause a disconnection of the base-connecting electrode crossing the arsenic-doped polycrystalline silicon film 29. Furthermore, since this arsenic-doped polycrystalline silicon film 29 is used as an interconnection layer for connections between the elements, this also tends to cause a disconnection from the second interconnection layer crossing thereover at the parts of the oxide film other than the element regions.

Secondly, it is impossible to make the arsenic-doped polycrystalline silicon film thicker than 3,000 Å for preventing this overhanging. It follows from this that it is impossible to reduce the resistance of the arsenic-doped polycrystalline silicon film as the wiring for connection with the collector electrode. Furthermore, since the arsenic-doped polycrystalline silicon film 29 is thermally oxidized at a low temperature (700 to 900°C) in the process shown in Fig. 3E, the wiring width becomes smaller and the wiring resistance becomes greater accordingly.

Thirdly, as shown in Fig. 3E, as method for forming the base contact holes and the collector region by the self-aligning technique, different growing speeds of the silicon oxide film by low-temperature oxidation of semiconductor layers due to different kinds of impurities or different impurity concentrations are utilized. The silicon oxide film 32a obtained by low-temperature oxidation of the $n^+$-type semiconductor layer of high concentration is formed to be several times thicker than the silicon oxide film 32b formed on the $p^-$-type semiconductor layer of low impurity concentration as the temperature for oxidation becomes lower. However, such a thick silicon oxide film is inferior in denseness, resulting in inferior insulating characteristics. Especially, when the silicon

oxide film obtained by oxidizing at 800°C the $n^+$-type polycrystalline silicon layer of high impurity concentration is etched in an HF-type solution, the insulating characteristics are very inferior. Although a silicon oxide film of 100 nm thickness formed by oxidation of a single-crystalline silicon layer at a high temperature (above 1,000°C) has a breakdown voltage of 80 to 90 V, the silicon oxide film of 200 nm thickness described above has a breakdown voltage of 10 to 20 V or less, occasionally becoming zero. When observations are made after thermal oxidation, the silicon oxide film 32a, grown on both sides of the arsenic-doped polycrystalline silicon film 29 over the base region 27 formed in the single crystalline silicon layer, grows less at the contact part with the single crystalline silicon layer (base region 27) and is recessed. Due to this, when the silicon oxide film 32b at both sides of the arsenic-doped polycrystalline silicon film is etched by an HF type etchant, the silicon oxide film 32a of the arsenic-doped polycrystalline silicon film 29 is inferior in denseness and weakly resistant to the etchant. Furthermore, since the contact part with the base region 27 is thinner as compared with other parts, the lower side surface of the arsenic-doped polycrystalline silicon film 29 of the collector region 31 is etched as shown in Fig. 6B, exposing the $n^+$-type collector region 31 formed by using the polycrystalline silicon film 29 as a diffusion source from the side surface of the polycrystalline silicon film 29. As a result, when the base connecting electrode 33 is formed, the electrode 33 contacts the exposed part of the collector region 31, thereby short-circuiting of the base and the collector.

It is an object of the present invention to provide a semiconductor device according to which the problems described above are solved and high performance and high integration are possible, and to further provide a method for fabricating the same.

According to the present invention, there is provided a method for fabricating a semiconductor device comprising the steps of:

forming a first insulating film having one or more openings on a semiconductor layer having a first semiconductor region of first conductivity type;
introducing an impurity of second conductivity type from said openings of said first insulating film to form a second semiconductor region in said semiconductor layer;
forming a second insulating film which has oxidation resistance and covers said first insulating film and part of said second semiconductor region;
forming a polycrystalline silicon layer on said second insulating film and a single-crystalline silicon layer on said exposed second semiconductor region;
etching said epitaxial layer using an etchant which etches polycrystalline silicon faster than single-crystalline silicon to form a projection consisting of the single-crystalline silicon and the part of the polycrystalline silicon contiguous therewith;
introducing an impurity of said first conductivity type in said projection to form a third semi-conductor region in said projection of single-crystalline silicon;
forming a third insulating film on the surface of said projection;
removing said second insulating film to form an electrode connecting opening of said second semiconductor region; and
forming an interconnection electrode layer connected with said second semiconductor region through said electrode connecting opening and insulated from said third semiconductor region by said third insulating film.

According to the present invention, there is also provided a method for fabricating a semiconductor device comprising the steps of:

forming a first insulating film having one or more openings on a semiconductor layer having a first semiconductor region of first conductivity type;
forming a second insulating film which has oxidation resistance and covers said first insulating film and part of said second semiconductor region;
forming a polycrystalline silicon layer on said second insulating film and a single-crystalline silicon layer on said exposed second semiconductor region;
etching said epitaxial layer using an etchant which etches polycrystalline silicon faster than single-crystalline silicon to form a projection consisting of the single-crystalline silicon and the part of the polycrystalline silicon contiguous therewith;
introducing an impurity of a second conductivity type to a low concentration in said projection to form a second semiconductor region in said projection of single-crystalline silicon;
introducing an impurity of said first conductivity type to a high concentration to the surface of said projection to form a third semiconductor region at the upper part of said projection of single-crystalline silicon;
forming a third insulating film on said projection;
removing said second insulating film;
introducing an impurity of the second conductivity type and of a higher concentration than in said second semiconductor region into said exposed first semiconductor region to form a fourth semiconductor region connected with said second semiconductor region; and
forming an interconnection electrode of a desired pattern.

According to the present invention, there is

also provided a semiconductor device comprising:

a semiconductor layer having a first semiconductor region of first conductivity type;
at least one projection consisting of a single-crystalline silicon layer formed on the surface of said semiconductor layer and a polycrystalline silicon layer contiguous therewith;
an insulating film formed on the surface of said projection;
a second semiconductor region of second conductivity type formed at the lower part of said single-crystalline silicon layer;
a third semiconductor region formed at the upper part of said single-crystalline silicon layer and connected with said second semiconductor region;
a fourth semiconductor region of higher impurity concentration and the same conductivity type as said second semiconductor region, said fourth semiconductor region formed in said first semiconductor region at both sides of said projection to be connected with said second semiconductor region; and
an interconnection electrode connected with said fourth semiconductor region and insulated from said third semiconductor region by said insulating film.

From the IEEE Journal of Solid-State Circuits, Vol. SC-14, No. 5, 1979, pages 876 to 887 a method for fabricating a semiconductor device is known comprising the steps of:

forming a first insulating film having one or more openings on a semiconductor layer having a first semiconductor region of first conductivity type;
introducing an impurity of second conductivity type from said openings of said first insulating film to form a second semiconductor region in said semiconductor layer;
forming a second insulating film which has oxidation resistance and covers said first insulating film and part of said second semiconductor region;
epitaxially growing silicon on the surface of the structure to form a polycrystalline silicon layer on said second insulating film and a single-crystalline silicon layer on said exposed second semiconductor region.

From the IBM Technical Disclosure Bulletin, Vol. 1, No. , 197, pages 3488 and 3489 it is known to use an etchant which etches polycrystalline silicon faster than single-crystalline silicon to form a projection consisting of the single-crystalline silicon and the part of the polycrystalline silicon contiguous therewith.

This invention can be more fully understood from the following detailed description when taken in conjunction with the accompanying drawings, in which:

Fig. 1 is a sectional view of a conventional npn type bipolar transistor;

Fig. 2 is a sectional view of a conventional $I^2L$;

Figs. 3A to 3F are sectional views illustrating a conventional method for fabricating the improved $I^2L$;

Fig. 4 is a plan view of Fig. 3F;

Fig. 5 is a sectional view along the line V—V of Fig. 4;

Fig. 6A is a sectional view illustrating the condition of the $I^2L$ after thermal oxidation in the step shown in Fig. 3E;

Fig. 6B is a sectional view illustrating the condition after etching in the step shown in Fig. 3E;

Figs. 7A to 7F are sectional views illustrating a method for fabricating an npn bipolar transistor according to an example of the present invention;

Figs. 8A and 8B are views illustrating the procedure between the step shown in Figs. 7C and 7D;

Fig. 9A is a top view of Fig. 7F;

Fig. 9B is a sectional view along the line B—B of Fig. 9A;

Fig. 10 is a sectional view of an npn bipolar transistor of double base structure;

Figs. 11A to 11H are views illustrating the method for fabricating an $I^2L$ of double base structure according to another example of the present invention;

Fig. 12 is a sectional view of a semiconductor device having both a high speed $I^2L$ and a high speed linear transistor;

Fig. 13 is a sectional view illustrating a semiconductor having both an $I^2L$ and a high voltage-resistance linear npn transistor;

Figs. 14A to 14G are sectional views illustrating a method for fabricating an $I^2L$ having a jumper wire according to another example of the present invention;

Fig. 15 is a plan view of Fig. 14G; and

Fig. 16 is a sectional view along the line X—X of Fig. 15.

The present invention has been made based on the finding that, when silicon is epitaxially grown on an insulating film, such as a silicon nitride layer or an alumina layer, formed on a semiconductor substrate and having a predetermined pattern and oxidation resistance characteristics, a polycrystalline silicon layer is formed on the insulating film and a single-crystalline silicon layer is formed on the semiconductor layer; the polycrystalline silicon layer alone is removed and a projection consisting of the single-crystalline silicon layer is formed when the epitaxial layer thus obtained is etched; and an opening is formed in the region of the semiconductor substrate in alignment with the oxide film on the surface of the projection, when an oxide film is formed on the surface of this projection and the insulating film is removed.

Preferred embodiments of the present

invention will now be described with reference to the accompanying drawings.

Example 1

This example is an application of the method of the present invention to a method for fabricating a bipolar npn transistor.

Referring to Fig. 7A, an $n^+$-type buried layer 42a is formed in a $p^-$-type semiconductor substrate 41, and an n-type epitaxial growth layer 43 is formed thereover. A $p^+$-type isolation layer 44 for isolating this n-type layer 43 is formed by diffusion. Next, as shown in Fig. 7B, an $n^+$-type diffusion layer 42b reaching to the $n^+$-type buried layer 42a for connection with the collector is formed by introducing an n-type impurity from a predetermined region of the surface of the n-type epitaxial layer 43. Thereafter, a silicon oxide film 45 is formed to a thickness of 500 nm. The silicon oxide film 45 is partially removed by photoetching. A p-type region 46 is formed as a base region by introducing a p-type impurity from this opening. An oxidation-resistive mask, e.g. silicon nitride film 47 of 100 nm thickness is deposited on the silicon oxide film 45 and the p-type region 46 to remove the desired part.

Vapor epitaxial growing of undoped silicon is performed thereover. At this time, an undoped single-crystalline silicon layer 48 of 500 nm thickness is formed on the exposed part of the p-type region 46 through the opening of the silicon nitride film 47, and an undoped polycrystalline silicon layer 49a of 500 nm thickness is formed on the silicon nitride film 47. A doped silicon layer may alternatively be formed in place of the undoped silicon layer during vapor growth. For example, it is possible to perform vapor growth by introducing an $n^+$-type impurity at high concentration such as phosphorus, arsenic, or antimony in monosilane ($SiH_4$). Alternatively, it is also possible to introduce an $n^-$-type or $p^-$-type impurity of low concentration in the undoped silicon layer formed by the vapor growth.

After thus simultaneously forming the single-crystalline silicon layer 48 and the polycrystalline silicon layer 49a, part of the polycrystalline silicon layer 49a, that is, the part for forming the connecting wiring for the emitter electrode, is covered with an etching-resistive mask, e.g. a photoresist film 50 as shown by the plan view of Fig. 8A. Using an etchant with a great difference in its etching rates for polycrystalline silicon and single-crystalline silicon, the polycrystalline silicon layer 49a is removed by etching to leave the single-silicon layer 58 projecting from the surface. At this time, part 49b of the polycrystalline silicon layer 49a covered with the photoresist film is also left so that the single crystalline silicon layer 48 and the remaining polycrystalline silicon layer 49b are connected in a manner as shown in Fig. 8B. The remaining polycrystalline silicon layer 49b is used as the connection wiring for the emitter electrode. A very high precision is not required in the alignment for the formation of the connection wiring of the emitter electrode described above. Thus, a small error does not pose any problem to the fabrication of elements of finer structure. For example, the photoresist may be shifted to the part 48 as the base region. An etchant having a great difference between its etching rates for polycrystalline silicon and single-crystalline silicon may include a liquid mixture of HF, $HNO_3$, and $CH_3COOH$; and a mixture of HF, $HNO_3$, $CH_3COOH$ and $H_2O$. The etching rate for polycrystalline silicon with such an etchant is several ten times that for the single-crystalline silicon. The etching rate also varies depending upon the kind and concentration of the impurity in the polycrystalline silicon or single-crystalline silicon. The selective etching described above may also be performed by the dry etching method using a gas etchant containing fluorocarbon such as Freon (RTM).

After removing the photoresist, an $n^+$-type impurity of high concentration is introduced into the single-crystalline silicon layer 48 by thermal diffusion or ion implantation to form an $n^+$-type semiconductor layer 51. The high-concentration $n^+$-type impurity is also introduced in the connecting wiring for the emitter electrode. It is also possible to perform this doping step of the $n^+$-type impurity before etching.

After diffusion an n-type impurity in the entirety of the emitter region which is the projection, the surface thereof is oxidized. Since the silicon nitride film 48 is not oxidized, the projecting $n^+$-type single-crystalline silicon layer 51 and the $n^+$-type polycrystalline silicon layer 49b are oxidized to provide silicon oxide films 52 and 53 of 300 nm thickness as shown in Figs. 7E and 9B. The growing temperature of the silicon oxide film may be within the range of 950 to 1,000°C or more. By oxidation at such a high temperature, the silicon oxide films 52 and 53 of improved denseness and insulating characteristics are formed on the surfaces of the $n^+$-type polycrystalline silicon layer 49b and the $n^+$-type single-crystalline silicon layer 51. It is possible to control the thickness of the silicon oxide films to a desired value by using arsenic or antimony as the $n^+$-type impurity so that the control of the current-amplification factor becomes extremely easy.

The base contact holes and the emitter region are formed by self-alignment by removing the silicon nitride film 47 by wet etching using a hot phosphoric acid, or by dry etching using a Freon-type etchant. After forming the collector contact hole, a metal layer is coated to a thickness of about 1.0 $\mu$m and is patterned to form a base electrode 54, a collector electrode 55, and an emitter electrode 56 to complete a bipolar npn transistor as shown in Fig. 7F. Fig. 9A is a top view of this transistor. Fig. 7F is a sectional view along the line A—A of Fig. 9A, and Fig. 9B is a sectional view along

the line B—B of Fig. 9A. When there is a danger that the n-type impurity of the emitter region diffuses in the transverse direction so that the base electrode 54 contacts the emitter region 51, such contact may be prevented by removing the silicon nitride film 47 by the step shown in Fig. 7E and introducing a high-concentration $p^{++}$-type impurity into the base region 46 by ion implantation or diffusion. By this measure, it is also possible to reduce the contact resistance between the base region 46 and the base electrode 54.

In a bipolar npn transistor obtained by the method described above, since the base contact hole and the emitter region 51 are formed by self-alignment by the selective epitaxial growth technique, the relation of the emitter side end of the base contact hole and the emitter region is determined by the thickness of the silicon oxide film 52 formed on the surface of the projecting emitter region. In a conventional bipolar npn transistor shown in Fig. 1, since the relation between the base contact hole and the emitter region is determined by the precision of alignment by photolithography, the distance between the emitter end of the base contact hole and the emitter region was required to be at least 3 $\mu$m, which is the sum of 2 $\mu$m required for error in alignment and 1 $\mu$m required for the side etching of the silicon oxide film in the contact hole. According to the method of the present invention, no limits are imposed on the finer structure of the element by the alignment error by the photoetching, and it is possible to form the base contact hole and the emitter region with the shortest distance therebetween correctly at a high yield. Accordingly, the base resistance may be minimized even in the case of an element having a shallow base region for high-speed operation. Furthermore, most of the surface of the base region 46 is covered by the metal layer 54. Thus, the base resistance becomes still smaller, resulting in an element of higher gain band product.

When compared with the $I^2L$ element described in "Sub-Nanosecond Self-Aligned $I^2L$/MTL Circuits" hereinabove, the element of the present invention exhibits excellent reliability and performance. Further, since the edge of the projection does not overhang when forming this projection but may be formed smooth, disconnection of the base electrode layer or disconnection of the other interconnection layer crossing thereover is effectively prevented. Since the surface of the projection is oxidized at a high temperature for a long period of time, a silicon oxide film with improved denseness and insulating characteristics is formed between the emitter region and the base electrode. Short-circuiting between the base and the emitter (between the base and the collector in the case of an $I^2L$) seldom occurs. The base contact hole may further be easily formed by wet etching the silicon nitride film with a hot phosphoric acid or by dry etching it with Freon or the like. It is possible to control the thickness of the single-crystalline silicon layer and the polycrystalline silicon layer with a high precision, i.e., to make the single-crystalline silicon layer thicker and the polycrystalline silicon layer thinner or vice versa, by varying the conditions of the vapor growth. For this reason, it is possible to reduce the emitter dynamic resistance and the resistance of the emitter electrode.

Furthermore, "emitter dip", which is one of the factors which obstruct the high-speed operation of the device and which is a common defect of conventional transistors, is avoided according to the method of the present invention. With a conventional semiconductor device of the type described hereinabove, so-called "emitter dip" is caused according to which the base region immediately below the emitter region is recessed because the emitter diffusion is performed in the diffusion region after the base diffusion. As is well known, the emitter dip greatly adversely affects the performance of the high-speed switching element. Since the projection for forming the emitter region is formed by the epitaxial growth technique in the method of the present invention, the emitter impurity need not be diffused deeply in the base region; thus, the emitter dip is avoided.

Example 2

A bipolar npn transistor obtained by this example is shown in Fig. 10.

According to this example, the base region is of double-base structure consisting of a $p^-$-type semiconductor layer (inner base) 46a and a $p^+$-type semiconductor layer (outer base) 46b, and the emitter region 51 is formed adjacent to the $p^-$-type semiconductor layer 46a, providing a bipolar npn transistor with reduced base-emitter junction capacity. Since the impurity concentration of the inner base 46a is low, a great current-amplification factor may be obtained. The method of this example is substantially the same as that of Example 1 except for the double base structure. The method for fabricating the double-base structure will be described with reference to the method for fabricating an $I^2L$ in Example 3.

Example 3

This example illustrates a case wherein the method of the present invention is applied to the method for fabricating an $I^2L$. The base employs the double-base structure as in the case of Example 2.

Referring to Fig. 11A, an n-type epitaxial layer 63 of 0.5 $\Omega$-cm resistivity and 2 $\mu$m thickness is formed on an $n^+$-type semiconductor substrate 62a. Thereafter, a silicon oxide film (not shown) of 500 nm thickness is formed over the entire surface. After removing the part corresponding to the emitter region, an n-type impurity is introduced through this opening to

form an $n^+$-type semiconductor layer 62b as the emitter (GND) region, and the silicon oxide film is removed.

Next, a silicon nitride film 65 is deposited to a thickness of 100 nm as shown in Fig. 11B. After selectively opening the silicon nitride film 58a by photoetching, the part of the n-type epitaxial layer 63 to become the isolation region is etched using the silicon nitride film 65 as a mask. Then, as shown in Fig. 11C, a silicon oxide film 64 of about 1.0 to 1.5 $\mu$m thickness is formed on the etched part of the epitaxial layer 63. This silicon oxide film 64 is called an oxide film collar, and surrounds the $I^2L$. After removing the silicon nitride film 65, another silicon oxide film of 500 nm thickness is formed and is then patterned by photoetching to provide a silicon oxide film 66. An oxidation-resistive film, e.g. a silicon nitride film 67 is deposited thereover to a thickness of 100 nm and the desired pattern is formed by photoetching.

Next, as shown in Fig. 11D, an undoped epitaxial layer of 500 nm thickness is formed. During this formation, a single-crystalline silicon layer 68 is formed on the exposed n-type epitaxial layer 63, and a polycrystalline silicon layer 69 is formed on the silicon nitride film 67.

By a method the same as that shown in Fig. 8A with reference to Example 1, part of the polycrystalline silicon layer 69, that is, the part to become the connecting wiring for the collector electrode, is covered with a etching-resistive mask, e.g. a photoresist film. Using an etchant with a great difference in its etching rates for polycrystalline silicon and single-crystalline silicon, the polycrystalline silicon layer 69 is removed to leave the single-crystalline silicon layer 68 projecting from the surface. During this etching, the part of the polycrystalline silicon layer 69 covered by the photoresist film also remains unetched. Thus, the remaining parts of the single-crystalline silicon layer 68 and of the polycrystalline silicon layer 69 are connected as shown in Fig. 8B.

After removing the photoresist, diffusion of a $p^-$-type impurity into the single-crystalline silicon layer 68 is performed to provide an inner base 70a of the $I^2L$. Since the thickness of the projecting single-crystalline silicon layer is about 0.5 $\mu$m and the inner base diffusion layer is formed to a depth of about 0.2 $\mu$m in the n-type epitaxial layer 63, the total thickness of this diffusion layer is about 0.7 $\mu$m. Then, an $n^+$-type semiconductor layer 71 used as the collector is formed on the surface of the diffusion layer 70a by diffusing an $n^+$-type impurity such as arsenic. This condition is shown in Fig. 11E. The polycrystalline silicon layer for connection with the collector electrode comprises the $n^+$-type region throughout the entire thickness. This is because the diffusion rate for the polycrystalline silicon layer is greater than that for the single-crystalline silicon layer.

In the next step, as shown in Fig. 11F, the surface of the projection is oxidized. Since this oxidation is performed at a high temperature of 1,000°C, the film thickness and quality do not depend much on the kind and concentration of the impurity in the substance to be oxidized and whether or not the substance to be oxidized is poly- or single-crystalline silicon. For example, an oxide film 72 of about 300 nm thickness is formed on the $n^+$-type single-crystalline silicon, and the oxide film 72 of about 320 to 330 nm thickness is formed on the $n^+$-type polycrystalline silicon. Both of these oxide films are dense and have superior insulating characteristics.

Thereafter, the silicon nitride film 67 is removed. A p-type impurity is introduced in the n-type epitaxial layer 63 by ion implantation or diffusion to form an injector region 73 and an outer base region 70b as shown in Fig. 11G. All the contact holes are opened and metal electrode layers 74a, 74b and 74c of about 1.0 $\mu$m thickness are formed to complete the $I^2L$.

The $I^2L$ fabricated in the manner described above has, in addition to the advantages of the devices in Examples 1 and 2, an additional advantage according to which the ratio of the emitter-base junction area to the collector-base junction area may be made near 1. Furthermore, since there is no alignment error due to photoetching in the formation of the injector, the base, and the collector which otherwise obstructs the fine structure of the element in this Example, $I^2L$s of high denseness and high performance may be fabricated at a high yield. Multi-interconnection may also be realized by using polycrystalline silicon for the interconnection layer, facilitating fabrication of LSIs of high integration.

Since the semiconductor device of Example 2 is fabricated in a manner similar to that of Example 3, an LSI of high integration incorporating both a high-speed $I^2L$ and a high-speed ECL (Emitter Coupled Logic), for example, may be easily fabricated by forming the $I^2L$ and the linear circuit on a single chip. An example of the semiconductor device thus obtained is shown in Fig. 12.

When both the $I^2L$ and the linear circuit are present, another advantage of high-voltage resistance (VCEO) of the linear circuit corresponding to the thickness of the n-type epitaxial layer 63 is obtained by performing n-type impurity epitaxial growth of the same concentration as that of the layer 63 in the step shown in Fig. 11D. Fig. 13 illustrates such a case.

Example 4

This example illustrates a case wherein an $I^2L$ is fabricated by forming the projection utilizing not only the difference in the etching rates depending on whether single-crystalline silicon or polycrystalline silicon is involved, but also the difference in the etching rates depending on the kind and concentration of the impurity, and the

jumper interconnection layer is formed simultaneously with the formation of the projection.

First, after an n-type silicon epitaxial layer 102 is formed on the $n^+$-type silicon layer 101 and an $n^+$-type diffusion layer 103 is formed on the epitaxial layer 102, they are subjected to selective oxidation to form a silicon oxide film 105 as an oxide film collar or an oxide insulating layer. A silicon nitride film 109 of 100 nm thickness as an oxidation-resistive insulating film, and an AsSG film 110 of 150 nm thickness containing an impurity, are formed in the order named on the entire surface of the structure (Fig. 14A).

Then, parts of the AsSG film 110 to become the collector connecting electrode and the jumper wiring are selectively etched away to form an AsSG film pattern 111. The parts of the silicon nitride film 109 covered with the AsSG pattern 111 are selectively etched to form an opening. Boron is thermally diffused into the n-type silicon epitaxial layer 102 through the opening to form a p-type inner base region 107 (Fig. 14B).

Silicon is then epitaxially grown on the entire surface in a boron atmosphere. During this step, a p-type single-crystalline silicon layer 124 of 400 nm thickness and of low concentration is formed on the part which is directly in contact with the p-type inner base region 107 consisting of the silicon epitaxial layer, a low-concentration boron-doped polycrystalline silicon layer 113a of the same thickness is formed on the silicon nitride film 109, and a high-concentration arsenic-doped polycrystalline silicon film 113b in which is diffused arsenic at high concentration from the pattern 111 is epitaxially formed on the AsSG film pattern 111 as shown in Fig. 14C.

Etching is then performed using an

$$HF—CH_3COOH—HNO_3—H_2O$$

type etchant having an etching selection ratio between a low-concentration boron-doped polycrystalline silicon. As shown in Fig. 14D, the etching rate of the high concentration arsenic-doped polycrystalline silicon film 113b is as fast as several ten times that of the low-concentration boron-doped polycrystalline silicon 113a, and is still faster than that of the single-crystalline silicon film 124. Due to this, the high concentration arsenic-doped polycrystalline silicon film 113b is selectively etched to form a projecting p-type single crystalline silicon film 124 formed integral with the p-type inner base region 107, a p-type polycrystalline silicon film pattern (not shown) formed integral therewith, and a p-type polycrystalline silicon pattern 114. Thereafter, the AsSG film 111 is removed.

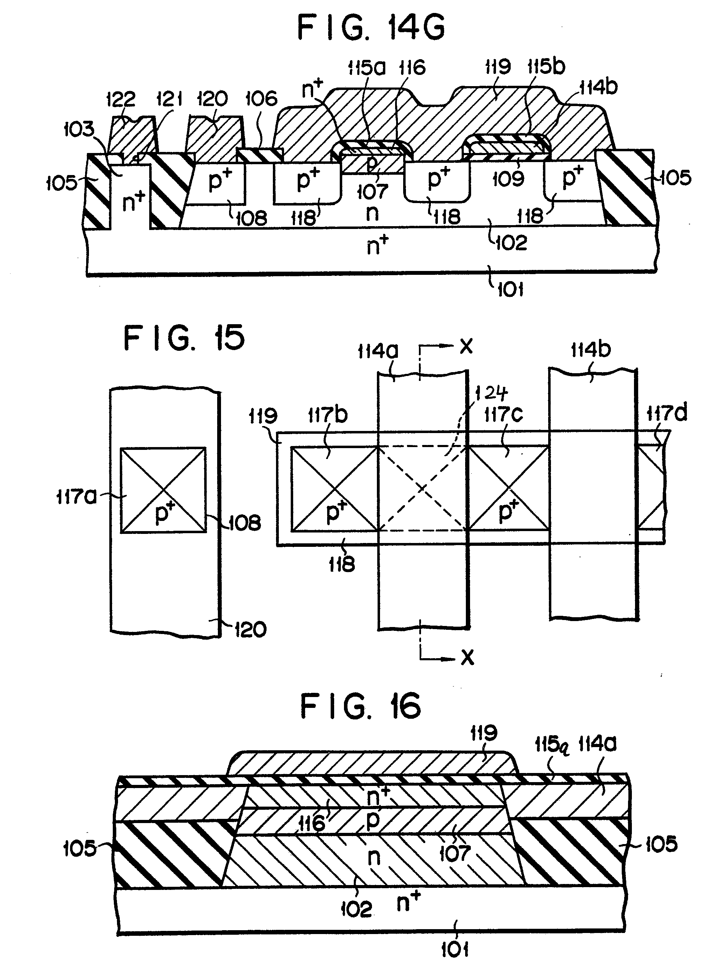

An $n^+$-type collector region 116 is formed on the projecting p-type single-crystalline silicon film 124 formed by diffusing arsenic, while converting the p-type polycrystalline silicon pattern (not shown) formed integral with the single-crystal silicon film 124 into an $n^+$-type pattern (114a in Fig. 15), and converting the p-type polycrystalline silicon pattern 114 into an $n^+$-type polycrystalline silicon pattern 114b. The structure is then subjected to thermal oxidation at 950°C. Then, a single-crystalline silicon as shown in Fig. 14E, an $n^+$-type polycrystalline silicon pattern (not shown) formed integral therewith, and oxide films 115a and 115b which are dense and superior in insulating characteristics and surrounding the pattern 114b are formed. Introduction of the oxidant into the silicon epitaxial film 102 in which is formed the silicon nitride film 109 is prevented. When a collector region 116 is formed, the $n^+$-type polycrystalline silicon pattern (not shown) formed integral therewith and located on the silicon oxide film 105 functions as a collector-connecting electrode, and the $n^+$-type polycrystalline silicon pattern 114b which is on the silicon nitride film 109 and the silicon oxide film 105, functions as a jumper wire.

Etching is then performed, with a wet etchant such as hot phosphoric acid which is used as an etchant of silicon nitrides, or with a Freon-type dry etchant, to selectively remove the silicon nitride film 109, and to form a single-crystalline silicon projection, an $n^+$-type polycrystalline silicon pattern (not shown) formed integral therewith, oxide films 115a and 115b surrounding an $n^+$-type polycrystalline silicon pattern 114b as a jumper wire, and window openings 117a to 117d self-aligned with respect to the thermally oxidized film 106. Boron of high concentration is ion-implanted using the window openings 117a to 117d described above as ion implantation windows to form a $p^+$-type injection region 108 in the silicon epitaxial layer 102 exposed through the window opening 117a, and to form a $p^+$-type outer base region 118 in the silicon epitaxial layer 102 exposed through the window openings 117b to 117d (Fig. 14F).

The $I^2L$ is completed by forming a base-connecting Al electrode 119, an injector-connecting Al electrode 120 and an emitter-connecting Al electrode 122 (Figs. 14G, 15 and 16). Fig. 15 is a plan view of Fig. 14G, and Fig. 16 is a sectional view along the line X—X of Fig. 15.

The $I^2L$ and the method for its fabrication described in this example have the same effects as in Example 3.

In the above-mentioned examples a projection or a single-crystalline silicon layer is formed by epitaxial growth of silicon. The method of providing the single-crystalline silicon layer is not limited to this. An energy beam such as a laser beam may be applied onto a polycrystalline silicon layer or amorphous silicon layer deposited by CVD or PVD, thereby changing that portion of the polycrystalline silicon layer or amorphous silicon layer which

contacts the semiconductor substrate to a single crystalline silicon layer.

Although bipolar transistors are fabricated in the above examples, the present invention is not necessarily limited to this application but may be applied to MOS transistors, field-effect transistors, and so on.

It is also possible to reverse the conductivity types, p-type and n-type, in the above examples.

**Claims**

1. A method for fabricating a semiconductor device comprising the steps of:

forming a first insulating film (45) having one or more openings on a semiconductor layer having a first semiconductor region of first conductivity type;
introducing an impurity of second conductivity type from said openings of said first insulating film (45) to form a second semiconductor region (46) in said semiconductor layer;
forming a second insulating film (47) which has oxidation resistance and covers said first insulating (45) film and part of said second semiconductor region (46);
forming a polycrystalline silicon layer (49a) on said second insulating film (47) and a single-crystalline silicon layer (48) on said exposed second semiconductor region (46);
etching said epitaxial layer using an etchant which etches polycrystalline silicon faster than single-crystalline silicon to form a projection consisting of the single-crystalline silicon (48) and the part (49b) of the polycrystalline silicon (49a) contiguous therewith;
introducing an impurity of said first conductivity type in said projection to form a third semiconductor region (51) in said projection of single-crystalline silicon;
forming a third insulating film (52) on the surface of said projection;
etching said second insulating film (47) to form an electrode connecting opening of said second semiconductor region (46); and
forming an interconnection electrode layer (54) connected with said second semiconductor region (46) through said electrode connecting opening and insulated from said third semiconductor region (51) by said third insulating film (52).

2. A method for fabricating a semiconductor device comprising the steps of:

forming a first insulating film (66) having one or more openings on a semiconductor layer (63) having a first semiconductor region of first conductivity type;
forming a second insulating film (67) which has oxidation resistance and covers said first insulating film (66) and part of said semiconductor layer.
forming a polycrystalline silicon layer (69) on said second insulating film (67) and a single-crystalline silicon layer (68) on said exposed semiconductor layer;
etching said epitaxial layer using an etchant which etches polycrystalline silicon faster than single-crystalline silicon to form a projection consisting of the single-crystalline silicon (68) and the part of the polycrystalline silicon (69) contiguous therewith;
introducing an impurity of a second conductivity type to a low concentration in said projection to form a second semiconductor region (70) in said projection of single-crystalline silicon;
introducing an impurity of said first conductivity type to a high concentration to the surface of said projection to form a third semiconductor region (71) at the upper part of said projection of single-crystalline silicon;
forming a third insulating film (72) on said projection;
removing said second insulating film (67);
introducing an impurity of the second conductivity type and of a higher concentration than in said second semiconductor region (70) into said exposed first semiconductor region to form a fourth semiconductor region (70b) connected with said second semiconductor region (70); and
forming an interconnection electrode (74a, 74b, 74c) of a desired pattern.

3. A method according to claim 1 or 2, wherein said polycrystalline (49a) and said single crystalline silicon layers (48) are formed by epitaxially growing silicon on the second insulating film (47) and the exposed second semiconductor region (46).

4. A method according to claim 1 and 3, wherein an undoped silicon layer is formed by said epitaxial growth.

5. A method according to claim 1 and 3, wherein an impurity-doped silicon layer is formed by said epitaxial growth.

6. A method according to claim 1 and 3, further comprising the step of introducing an impurity of said first conductivity type in said epitaxial layer before etching said epitaxial layer.

7. A method according to claim 1 and 3, further comprising the step of introducing an impurity of high concentration and of said second conductivity type in said second semiconductor region (46) after removing said second insulating film (47).

8. A method according to claim 3, wherein etching of said epitaxial layer is performed under the condition that an etching resistive mask covers the contiguous part of said poly-

crystalline silicon and said single-crystalline silicon.

9. A method according to claim 3, wherein an etchant used for the etching of said epitaxial layer is a member selected from the group consisting of a mixture of HF, $HNO_3$, and $CH_3COOH$ and a mixture of HF, $HNO_3$, $CH_3COOH$, and $H_2O$, and a gas etchant containing fluorocarbon.

10. A method according to claim 2 and 3, further comprising the steps of forming a fourth insulating film (111) having at least one opening and containing an impurity on said second insulating film (109); performing a heat treatment after said epitaxial growth and diffusing the impurity in said fourth insulating layer into said polycrystalline silicon layer thereover to selectively form an impurity-doped region (113b) in said polycrystalline silicon layer; and removing said fourth insulating layer after etching said epitaxial layer to leave said undoped polycrystalline silicon layer (114a) on said second insulating layer (109).

11. A method according to claim 1 or 2, wherein said polycrystalline (49a) and said single crystalline silicon layers (48) are formed by depositing polycrystalline silicon or amorphous silicon on the surface of the structure and applying an energy beam thereto to form a polycrystalline silicon layer (49a) on said second insulating film (47) and a single-crystalline silicon layer (48) on said exposed second semiconductor region (46).

12. A semiconductor device comprising:

a semiconductor layer having a first semiconductor region of first conductivity type;
at least one projection consisting of a single-crystalline silicon layer (46a, 51) formed on the surface of said semiconductor layer and a polycrystalline silicon layer contiguous therewith;
an insulating film (52) formed on the surface of said projection;
a second semiconductor region (46a) of second conductivity type formed at the lower part of said single-crystalline silicon layer;
a third semiconductor region (51) formed at the upper part of said single-crystalline silicon layer and connected with said second semiconductor region (46a);
a fourth semiconductor region (46b) of higher impurity concentration and the same conductivity type as said second semiconductor region (46a), said fourth semiconductor region (46b) formed in said first semiconductor region at both sides of said projection to be connected with said second semiconductor region (46a); and
an interconnection electrode (54) connected with said fourth semiconductor region (46b) and insulated from said third semiconductor region (51) by said insulating film (52), (Fig. 10).

13. A semiconductor device according to claim 12, wherein said polycrystalline silicon layer is used as an electrode-connecting wire for said third semiconductor region.

**Patentansprüche**

1. Verfahren zur Herstellung einer Halbleitervorrichtung, dadurch gekennzeichnet, daß man auf einer Halbleiterschicht mit einem ersten Halbleiterbereich eines ersten Leitfähigkeitstyps eine erste isolierende Schicht oder Lage (45) mit einer oder mehreren Öffnung(en) ausbildet, zur Bildung eines zweiten Halbleiterbereichs (46) in der Halbleiterschicht über die Öffnung(en) der ersten isolierenden Schicht (45) ein Fremdatom eines zweiten Leitfähigkeitstyps einführt, eine oxidationsbeständige und die erste isolierende Schicht (45) und einen Teil des zweiten Halbleiterbereichs (46) bedeckende zweite isolierende Schicht (47) erzeugt, auf der zweiten isolierenden Schicht (47) eine polykristalline Siliziumschicht (49a) und auf dem freiliegenden zweiten Halbleiterbereich (46) eine Siliziumeinkristall-Schicht (48) ausbildet, die (durch epitaxiales Aufwachsen) gebildete Schicht mit einem das polykristalline Silizium rascher als den Siliziumeinkristall (weg)ätzenden Ätzmittel ätzt, um einen aus dem Siliziumeinkristall (48) und dem angrenzenden Teil (49b) des polykristallinen Siliziums (49a) bestehenden Vorsprung zu bilden, zur Ausbildung eines dritten Halbleiterbereiches (51) in dem Vorsprung aus dem Siliziumeinkristall in diesen ein Fremdatom des ersten Leitfähigkeitstyps einführt, auf der Oberfläche des Vorsprungs eine dritte isolierende Schicht (52) ausbildet, zur Bildung einer Elektrodenanschlußöffnung des zweiten Halbleiterbereichs (45) die zweite isolierende Schicht (47) (weg)ätzt und eine Verbindungselektrodenschicht (54), die mit dem zweiten Halbleiterbereich (46) über die Elektrodenanschlußöffnung in Verbindung steht und gegen den dritten Halbleiterbereich (51) mittels der dritten isolierenden Schicht (52) isoliert ist, erzeugt.

2. Verfahren zur Herstellung einer Halbleitervorrichtung, dadurch gekennzeichnet, daß man auf einer Halbleiterschicht (63) mit einem ersten Halbleiterbereich eines ersten Leitfähigkeitstyps eine erste isolierende Schicht oder Lage (66) mit einer oder mehreren Öffnung(en) ausbildet, eine oxidationsbeständige und die erste isolierende Schicht (66) und einen Teil der Halbleiterschicht bedeckende Isolierschicht (67) erzeugt, auf der zweiten isolierenden Schicht (67) eine polykristalline Siliziumschicht (69) und auf der freiliegenden Halbleiterschicht eine Siliziumeinkristall-Schicht (68) ausbildet, die (durch epitaxiales Aufwachsen) gebildete Schicht mit einem das polykristalline Silizium rascher als den Siliziumeinkristall (weg)ätzenden Ätzmittel ätzt, um einen aus dem Siliziumeinkristall (68) und dem angrenzenden Teil (69) des polykristallinen Siliziums bestehenden Vorsprung zu bilden, zur Bildung eines zweiten

Halbleiterbereiches (70) in dem Vorsprung aus dem Siliziumeinkristall in diesen ein Fremdatom eines zweiten Leitfähigkeitstyps in niedriger Konzentration einführt, zur Bildung eines dritten Halbleiterbereiches (71) am oberen Teil des Vorsprungs aus dem Siliziumeinkristall in die Vorsprungoberfläche ein Fremdatom des ersten Leitfähigkeitstyps in hoher Konzentration einführt, auf dem Vorsprung eine dritte isolierende Schicht (72) ausbildet, die zweite isolierende Schicht (67) entfernt, zur Bildung eines vierten Halbleiterbereichs (70b) in den freiliegenden ersten Halbleiterbereich ein Fremdatom des zweiten Leitfähigkeitstyps in höherer Konzentration, als sie in dem zweiten Halbleiterbereich (70) herrscht, einführt, und eine Verbindungselektrode (74a, 74b, 74c) des gewünschten Musters ausbildet.

3. Verfahren nach Anspruch 1 oder 2, dadurch gekennzeichnet, daß man auf der zweiten isolierenden Schicht (47, 67) und dem freiliegenden zweiten Halbleiterbereich (46, 63) die polykristalline Siliziumschicht (49a, 69) bzw. die Siliziumeinkristallschicht (48, 68) durch epitaxiales Aufwachsen von Silizium ausbildet.

4. Verfahren nach Ansprüchen 1 und 3, dadurch gekennzeichnet, daß man die epitaxiales Aufwachsen eine undotierte Siliziumschicht erzeugt.

5. Verfahren nach Ansprüchen 1 und 3, dadurch gekennzeichnet, daß man durch epitaxiales Aufwachsen eine fremdatomdotierte Siliziumschicht erzeugt.

6. Verfahren nach Ansprüchen 1 und 3, dadurch gekennzeichnet, daß man zusätzlich in die durch epitaxiales Aufwachsen gebildete Schicht vor deren Ätzen ein Fremdatom des ersten Leitfähigkeitstyps einführt.

7. Verfahren nach Ansprüchen 1 und 3, dadurch gekennzeichnet, daß man zusätzlich in den zweiten Halbleiterbereich (46) nach Entfernen der zweiten isolierenden Schicht (47) ein Fremdatom des zweiten Leitfähigkeitstyps in hoher Konzentration einführt.

8. Verfahren nach Anspruch 3, dadurch gekennzeichnet, daß man die durch epitaxiales Aufwachsen gebildete Schicht unter solchen Bedingungen ätzt, daß eine ätzbeständige Maske die aneinander angrenzenden Bereiche des polykristallinen Siliziums und des Siliziumeinkristalls bedeckt.

9. Verfahren nach Anspruch 3, dadurch gekennzeichnet, daß man zum Ätzen der durch epitaxiales Aufwachsen gebildeten Schicht ein Gemisch aus HF, $HNO_3$ und $CH_3COOH$, ein Gemisch aus HF, $HNO_3$, $CH_3COOH$ und $H_2O$ oder ein gasförmiges Ätzmittel mit einem Fluorkohlenstoff verwendet.

10. Verfahren nach Ansprüchen 2 und 3, dadurch gekennzeichnet, daß man zusätzlich auf der zweiten isolierenden Schicht (109) eine vierte isolierende Schicht (111) mit mindestens einer Öffnung und einem Fremdatomgehalt ausbildet, nach dem epitaxialen Aufwachsen eine Wärmebehandlung durchführt und das in der vierten isolierenden Schicht enthaltene Fremdatom zur selektiven Ausbildung eines fremdatomdotierten Bereiches (113b) in der polykristallinen Siliziumschicht in die polykristalline Siliziumschicht diffundieren läßt und schließlich nach dem (Weg)ätzen der durch epitaxiales Aufwachsen gebildeten Schicht die vierte isolierende Schicht entfernt, wobei die undotierte polykristalline Siliziumschicht (114a) auf der zweiten isolierenden Schicht (109) verbleibt.

11. Verfahren nach Anspruch 1 oder 2, dadurch gekennzeichnet, daß man die polykristalline Siliziumschicht (49a, 69) und die Siliziumeinkristall-Schicht (48, 68) dadurch ausbildet, daß man auf der Oberfläche des Bauteils polykristallines oder amorphes Silizium ablagert und darauf Strahlungsenergie einwirken läßt, um auf der zweiten isolierenden Schicht (47, 67) eine polykristalline Siliziumschicht (49a, 69) und auf dem freiliegenden Halbleiterbereich (46, 63) eine Siliziumeinkristall-Schicht (48, 68) auszubilden.

12. Halbleitervorrichtung, gekennzeichnet durch eine Halbleiterschicht mit einem ersten Halbleiterbereich eines ersten Leitfähigkeitstyps, mindestens einen Vorsprung aus einer auf der Oberfläche der Halbleiterschicht gebildeten Siliziumeinkristall-Schicht (46a, 51) und einer daran angrenzenden polykristallinen Siliziumschicht, eine auf der Oberfläche des Vorsprungs gebildete isolierende Schicht (52), einem am unteren Teil der Siliziumeinkristall-Schicht gebildeten zweiten Halbleiterbereich (46a) eines zweiten Leitfähigkeitstyps, einen am oberen Teil der Siliziumeinkristall-Schicht gebildeten und mit dem zweiten Halbleiterbereich (46a) in Verbindung stehenden dritten Halbleiterbereich (51), einen vierten Halbleiterbereich (46b) höherer Fremdatomkonzentration, als sie der zweite Halbleiterbereich (46a) aufweist, und desselben Leitfähigkeitstyps wie der zweite Halbleiterbereich (46a), wobei der vierte Halbleiterbereich (46b) in dem ersten Halbleiterbereich an beiden Seiten des Vorsprungs derart ausgebildet ist, daß er mit dem zweiten Halbleiterbereich (46a) in Verbindung steht, und eine mit dem vierten Halbleiterbereich (46b) verbundene und von dem dritten Halbleiterbereich (51) durch die isolierende Schicht (52) isolierte Verbindungselektrode (54) (Fig. 10).

13. Halbeleitervorrichtung nach Anspruch 12, dadurch gekennzeichnet, daß die polykristalline Siliziumschicht als Elektrodenanschlußleiter für den dritten Halbleiterbereich dient.

**Revendications**

1. Un procédé pour la fabrication d'un dispositif semiconducteur comprenant les opérations suivantes:

on forme une première couche isolante (45) ayant une ou plusieurs ouvertures, sur une couche semiconductrice ayant une première région semiconductrice d'un premier type de conductivité;

on introduit une impureté d'un second type de conductivité, par lesdites ouvertures de la première couche isolante (45), pour former une seconde région semiconductrice (46) dans la couche semiconductrice;

on forme une seconde couche isolante (47) qui résiste à l'oxydation et qui recouvre la première couche isolante (45) et une partie de la seconde région semiconductrice (46);

on forme une couche de silicium polycristallin (49a) sur la seconde couche isolante (47) et une couche de silicium monocristallin (48) sur la seconde région semiconductrice à nu (46);

on attaque la couche épitaxiale en utilisant un agent d'attaque qui attaque plus rapidement le silicium polycristallin que le silicium monocristallin, pour former une partie en saillie constituée par le silicium monocristallin (48) et par la partie (49b) du silicium polycristallin (49a) qui lui est contiguë;

on introduit une impureté du premier type de conductivité dans la partie en saillie, pour former une troisième région semiconductrice (51) dans la partie en saillie en silicium monocristallin;

on forme une troisième couche isolante (52) sur la surface de la partie en saillie;

on attaque la seconde couche isolante (47) pour former une ouverture de connexion d'électrode de la seconde région semiconductrice (46); et

on forme une couche d'électrode d'interconnexion (54) connectée à la seconde région semiconductrice (46) à travers l'ouverture de connexion d'électrode, et isolée de la troisième région semiconductrice (51) par la troisième couche isolante (52).

2. Un procédé pour la fabrication d'un dispositif semiconducteur comprenant les opérations suivantes:

on forme une première couche isolante (66) ayant une ou plusieurs ouvertures, sur une couche semiconductrice (63) ayant une première région semiconductrice d'un premier type de conductivité;

on forme une seconde couche isolante (67) qui résiste à l'oxydation et qui recouvre la première couche isolante (66) et une partie de la couche semiconductrice;

on forme une couche de silicium polycristallin (69) sur la seconde couche isolante (67) et une couche de silicium monocristallin (68) sur la couche semiconductrice à nu;

on attaque la couche épitaxiale en utilisant un agent d'attaque qui attaque plus rapidement le silicium polycristallin que le silicium monocristallin, pour former une partie en saillie constituée par le silicium monocristallin (68) et par la partie du silicium polycristallin (69) qui lui est contiguë;

on introduit une impureté d'un second type de conductivité, avec une faible concentration, dans la partie en saillie, pour former une seconde région semiconductrice (70) dans la partie en saillie en silicium monocristallin;

on introduit une impureté du premier type de conductivité, avec une concentration élevée, à la surface de la partie en saillie, pour former une troisième région semiconductrice (71) dans la zone supérieure de la partie en saillie en silicium monocristallin;

on forme une troisième couche isolante (72) sur la partie en saillie;

on enlève la seconde couche isolante (67);

on introduit dans la première région semiconductrice à nu une impureté ayant le second type de conductivité et une concentration plus élevée que dans la seconde région semiconductrice (70), pour former une quatrième région semiconductrice (70b) connectée à la seconde région semiconductrice (70); et

on forme une électrode d'interconnexion (74a, 74b, 74c) ayant un motif désiré.

3. Un procédé selon la revendication 1 ou 2, dans lequel les couches de silicium polycristallin (49a) et de silicium monocristallin (48) sont formées par croissance épitaxiale de silicium sur la seconde couche isolante (47) et sur la seconde région semiconductrice à nu (46).

4. Un procédé selon les revendications 1 et 3, dans lequel la croissance épitaxiale forme une couche de silicium non dopé.

5. Un procédé selon les revendications 1 et 3, dans lequel la croissance épitaxiale forme une couche de silicium dopé par une impureté.

6. Un procédé selon les revendications 1 et 3, comprenant en outre l'opération qu consiste à introduire une impureté du premier type de conductivité dans la couche épitaxiale, avant d'attaquer cette couche épitaxiale.

7. Un procédé selon les revendications 1 et 3, comprenant en outre l'opération qui consiste à introduire une impureté du second type de conductivité et de concentration élevée dans la seconde région semiconductrice (46) après enlèvement de la seconde couche isolante (47).

8. Un procédé selon la revendication 3, dans lequel on effectue l'attaque de la couche épitaxiale dans des conditions dans lesquelles un masque résistant à l'attaque recouvre la partie contiguë du silicium polycristallin et du silicium monocristallin.

9. Un procédé selon la revendicaton 3, dans lequel on utilise pour l'attaque de la couche épitaxiale un agent d'attaque qui fait partie du groupe comprenant un mélange de HF, $HNO_3$, et $CH_3COOH$ et un mélange de HF, $HNO_3$, $CH_3COOH$ et $H_2O$, et un agent d'attaque gazeux contenant un composé fluorocarboné.

10. Un procédé selon la revendications 2 et

3, comprenant en outre les opérations suivantes: on forme sur la seconde couche isolante (109) une quatrième couche isolante (111) ayant au moins une ouverture et contenant une impureté; on accomplit un traitement thermique après la croissance épitaxiale et on fait diffuser l'impureté de la quatrième couche d'isolation vers la couche de silicium polycristallin qui la recouvre, pour former sélectivement une région dopée par une impureté (113b) dans la couche de silicium polycristallin; et on enlève la quatrième couche isolante après attaque de la couche épitaxiale, pour laisser la couche de silicium polycristallin non dopé (114a) sur la seconde couche isolante (109).

11. Un procédé selon la revendication 1 ou 2, dans lequel les couches de silicium polycristallin (49a) et de silicium monocristallin (48) sont formées en déposant du silicium polycristallin ou du silicium amorphe sur la surface de la structure et en lui appliquant un faisceau d'énergie pour former une couche de silicium polycristallin (49a) sur la seconde couche isolante (47) et une couche de silicium monocristallin (48) sur la seconde région semiconductrice à nu (46).

12. Un dispositif semiconducteur comprenant:

une couche semiconductrice ayant une première région semiconductrice d'un premier type de conductivité;
au moins une partie en saillie constituée par une couche de silicium monocristallin (46a, 51) formée sur la surface de la couche semiconductrice et par une couche de silicium polycristallin qui lui est contiguë;
une couche isolante (52) formée sur la surface de la partie en saillie;
une seconde région semiconductrice (46a) d'un second type de conductivité formée dans la partie inférieure de la couche de silicium monocristallin;
une troisième région semiconductrice (51) formée dans la partie supérieure de la couche de silicium monocristallin et connectée à la seconde région semiconductrice (46a);
une quatrième région semiconductrice (46b) ayant le même type de conductivité que la seconde région semiconductrice (46a) et une concentration en impureté plus élevée, cette quatrième région semiconductrice (46b) étant formée dans la première région semiconductrice, de part et d'autre de la partie en saillie, de façon à être connectée à la seconde région semiconductrice (46a); et
une électrode d'interconnexion (54) connectée à la quatrième région semiconductrice (46b) et isolée de la troisième région semiconductrice (51) par la couche isolante (52) (figure 10).

13. Un dispositif semiconducteur selon la revendication 12, dans lequel la couche de silicium polycristallin est utilisée en tant que fil de connexion d'électrode pour la troisième région semiconductrice.

FIG. 1

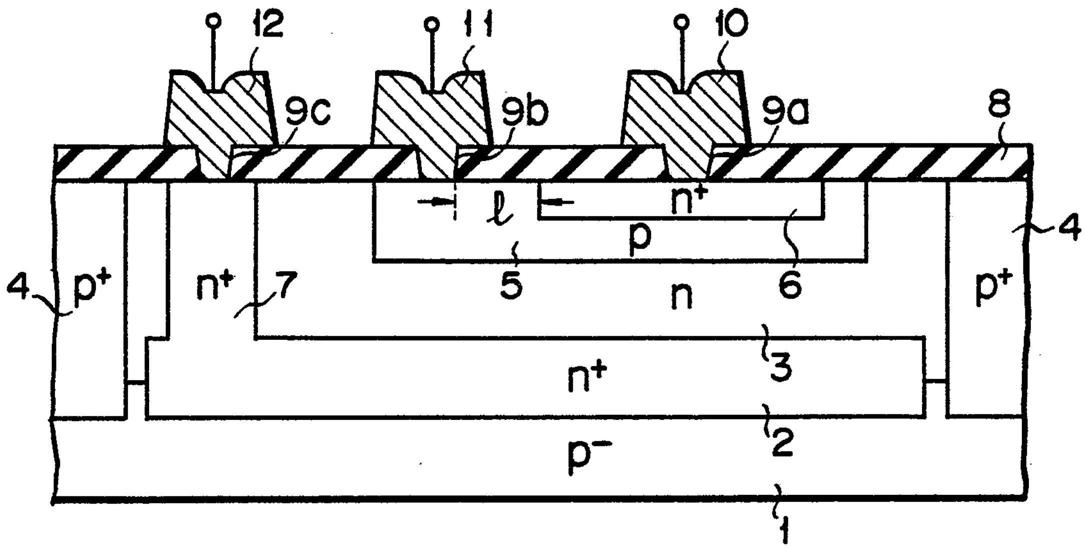


FIG. 2

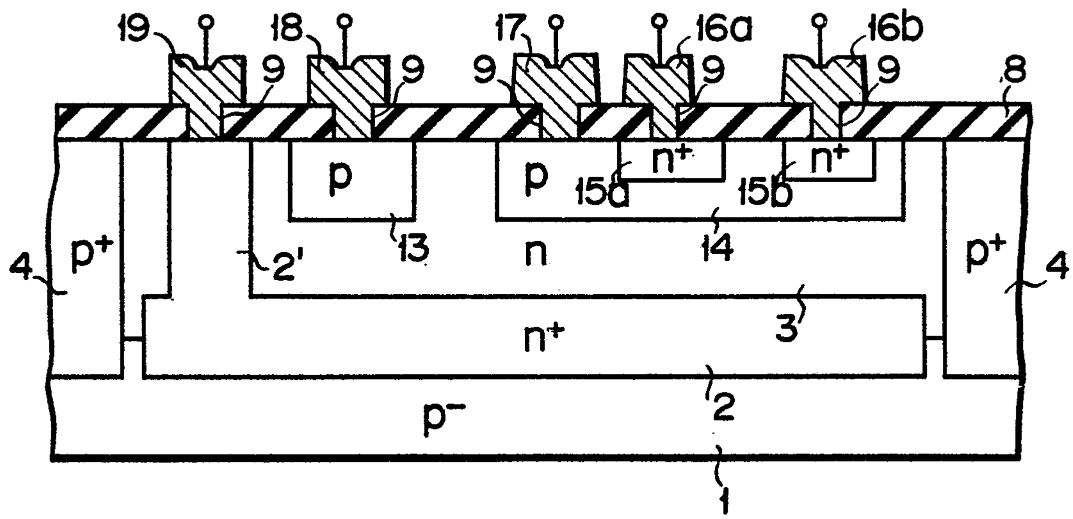


FIG. 3A

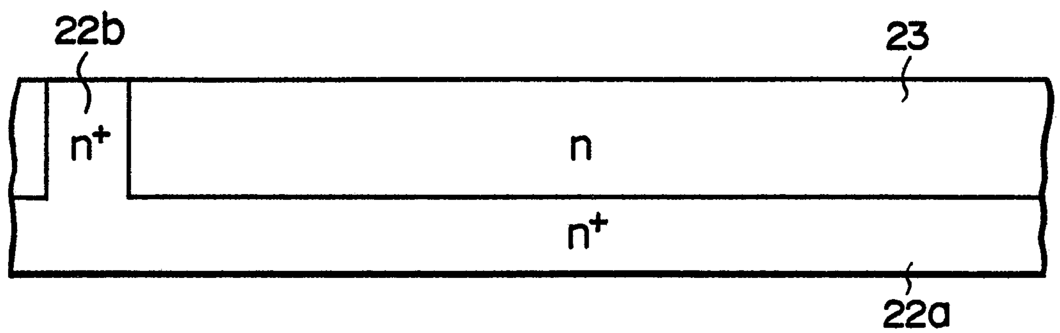

FIG. 3B

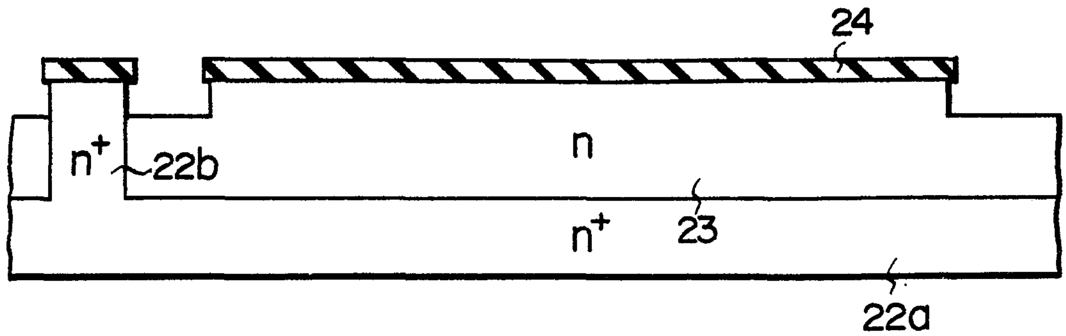


FIG. 3C

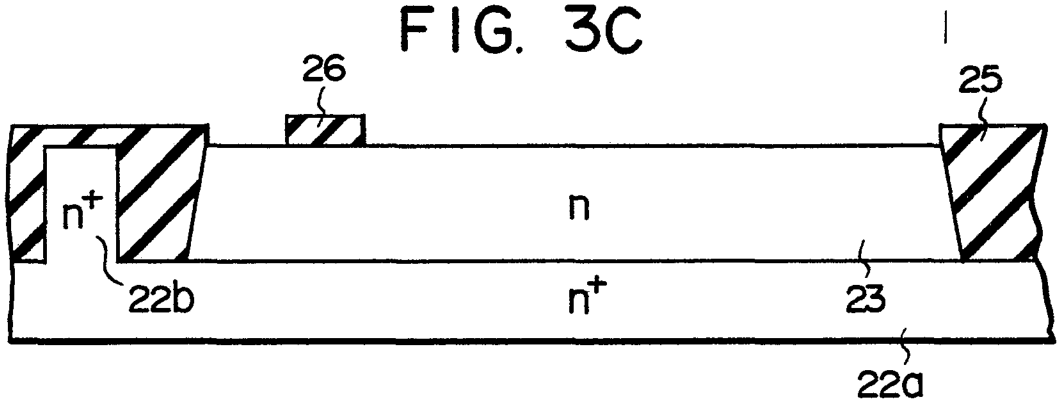


FIG. 3D

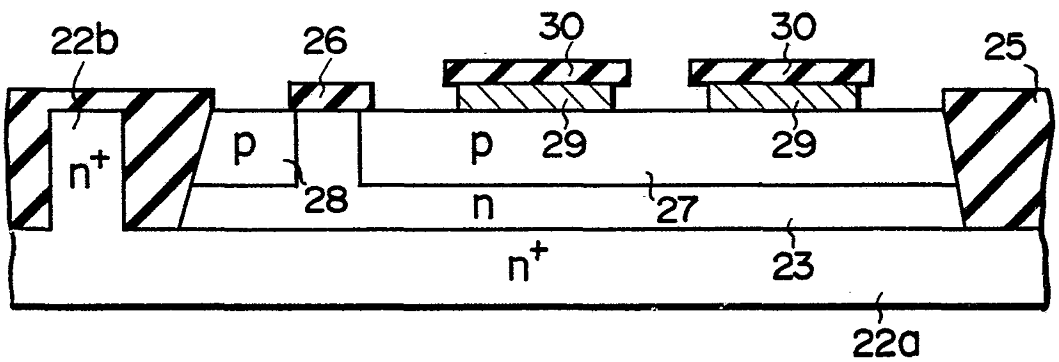


FIG. 3E

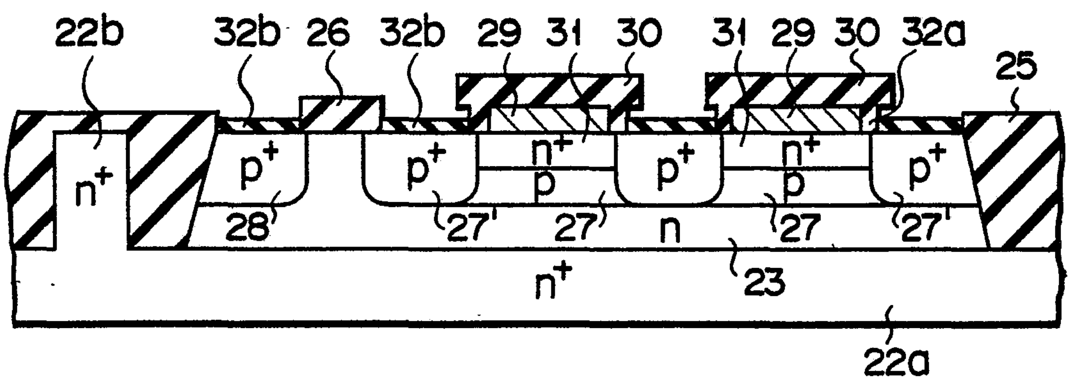

FIG. 3F

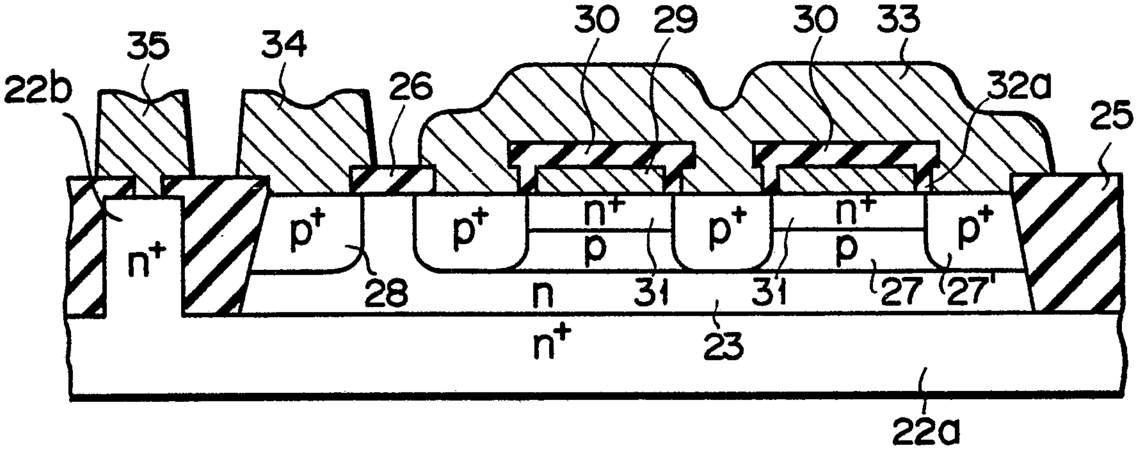


FIG. 4

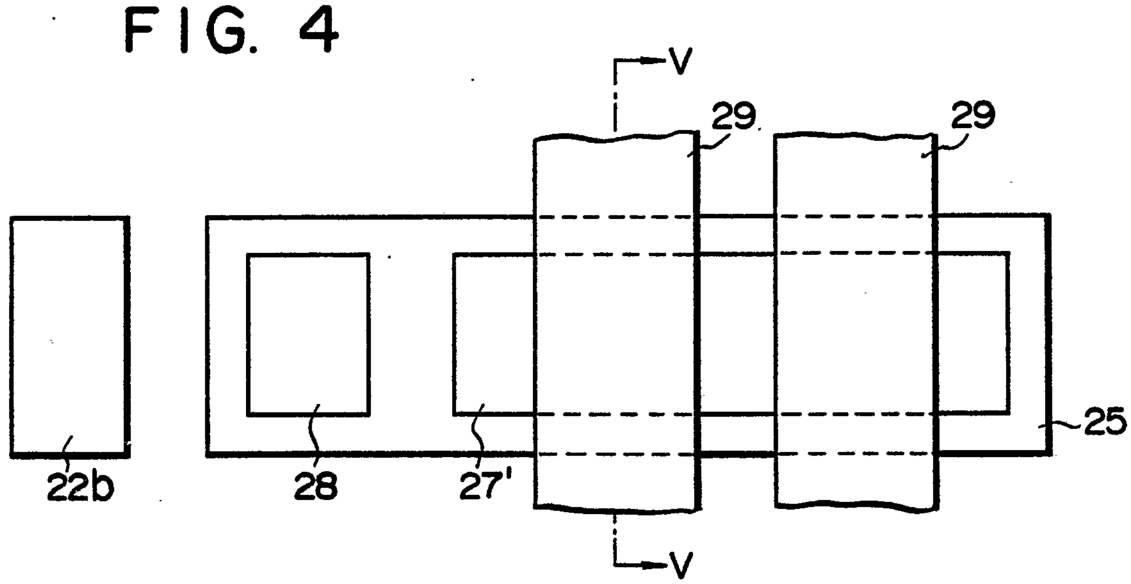


FIG. 5

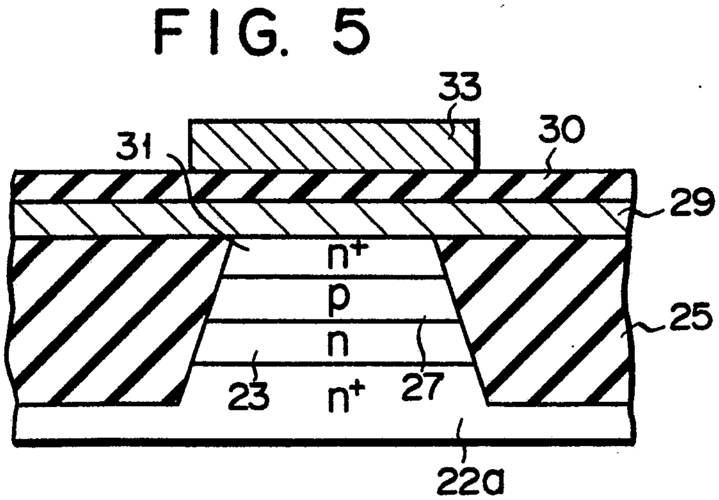

FIG. 6A

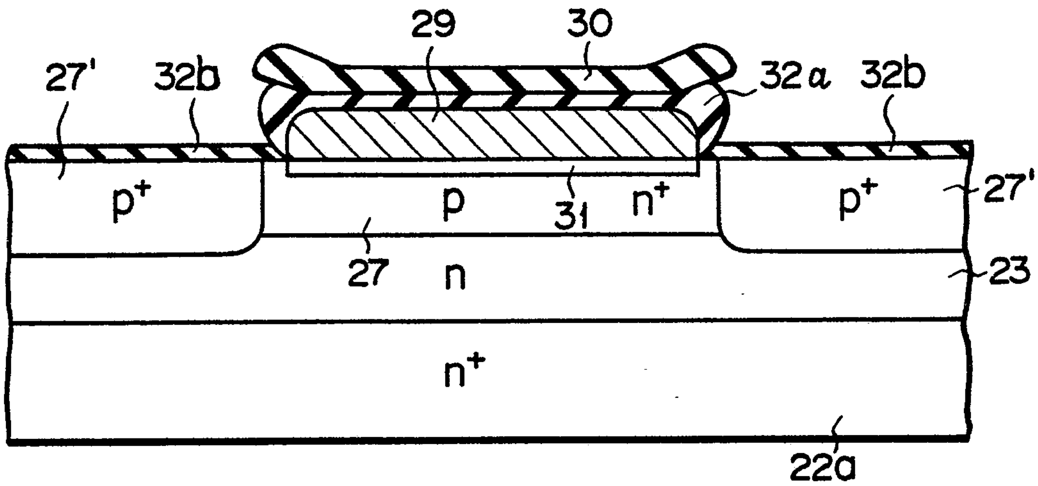


FIG. 6B

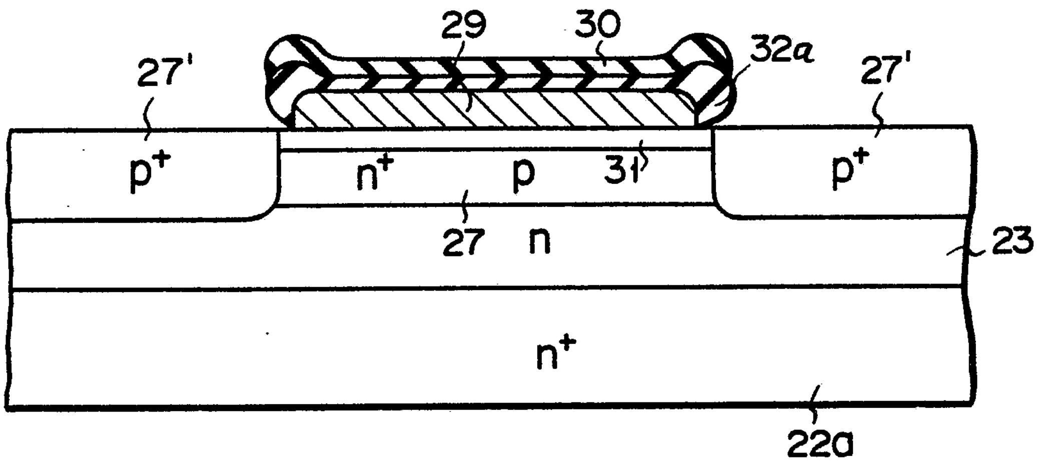


FIG. 7A

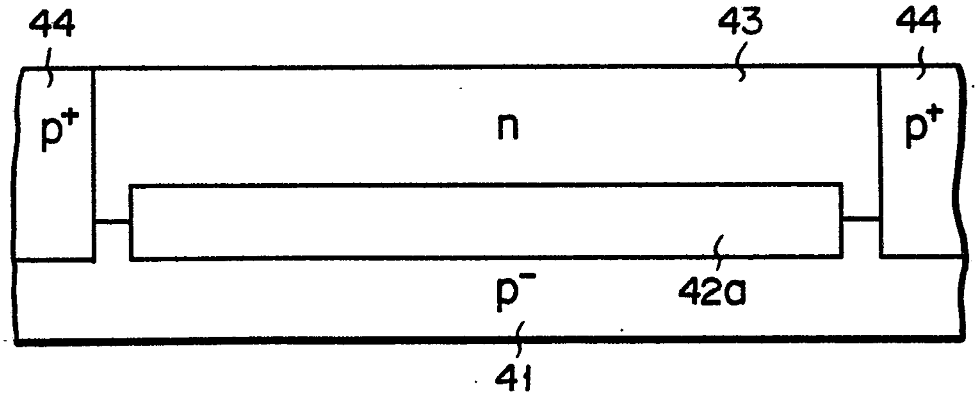

FIG. 7B

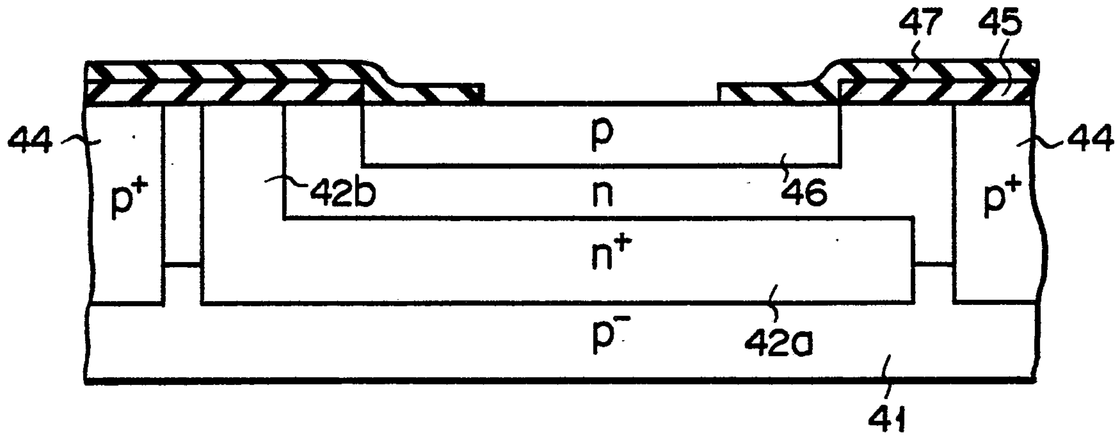


FIG. 7C

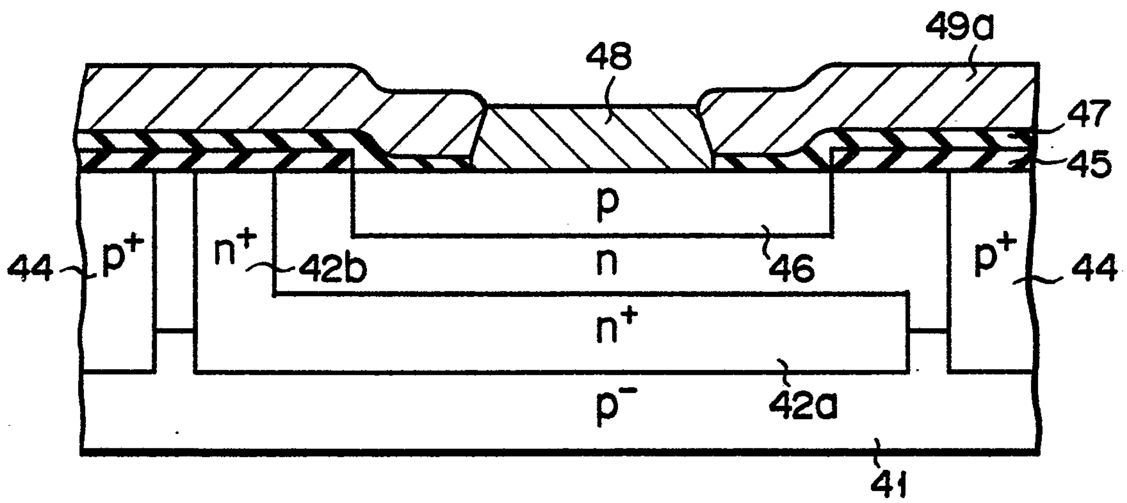


FIG. 7D

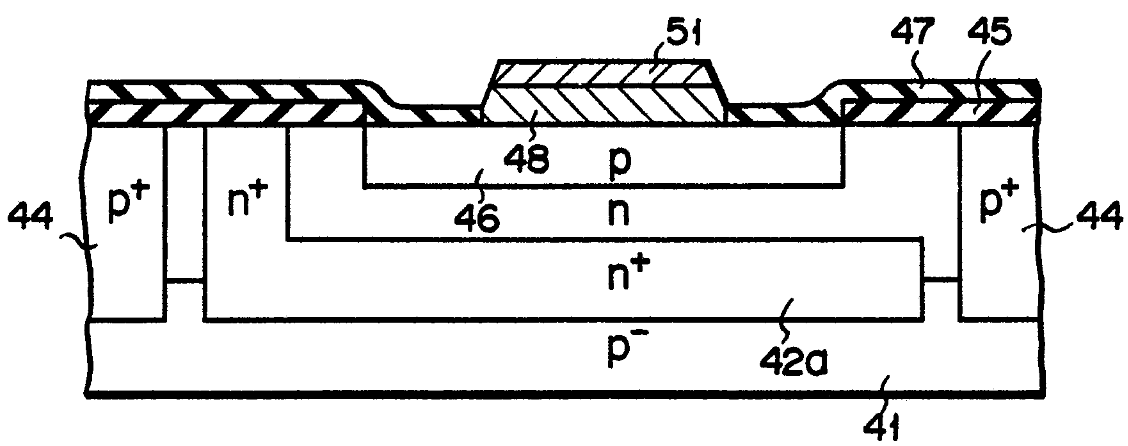

FIG. 7E

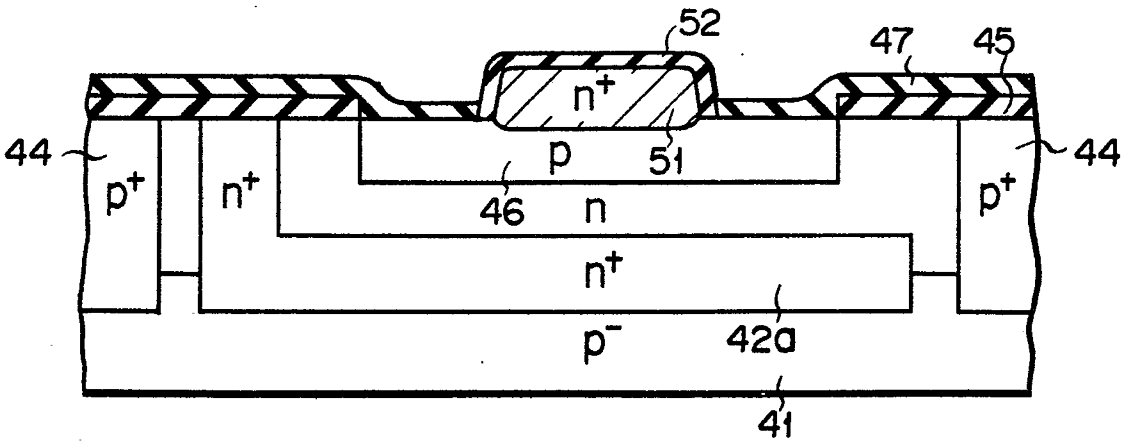


FIG. 7F

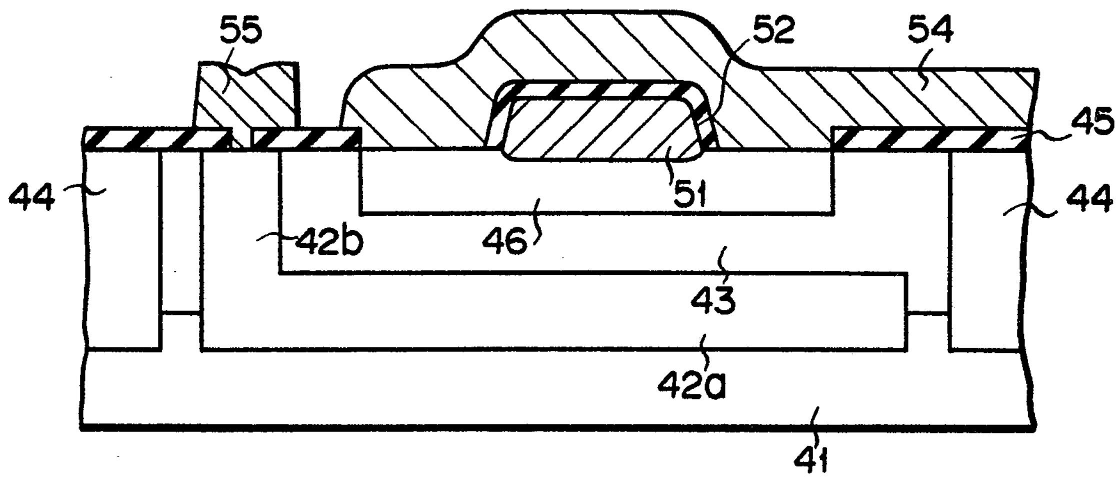


FIG. 8A

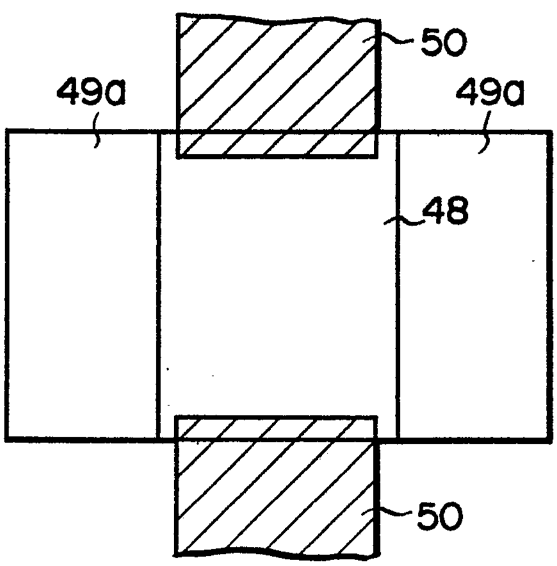


FIG. 8B

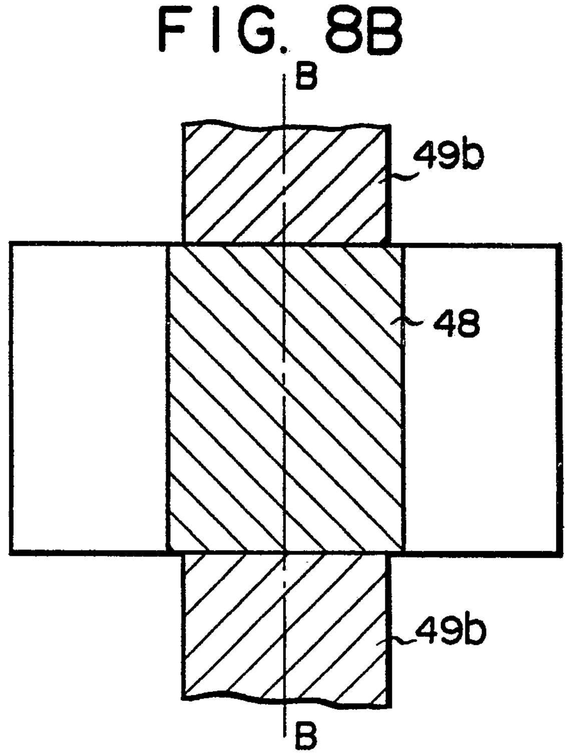

FIG. 9A

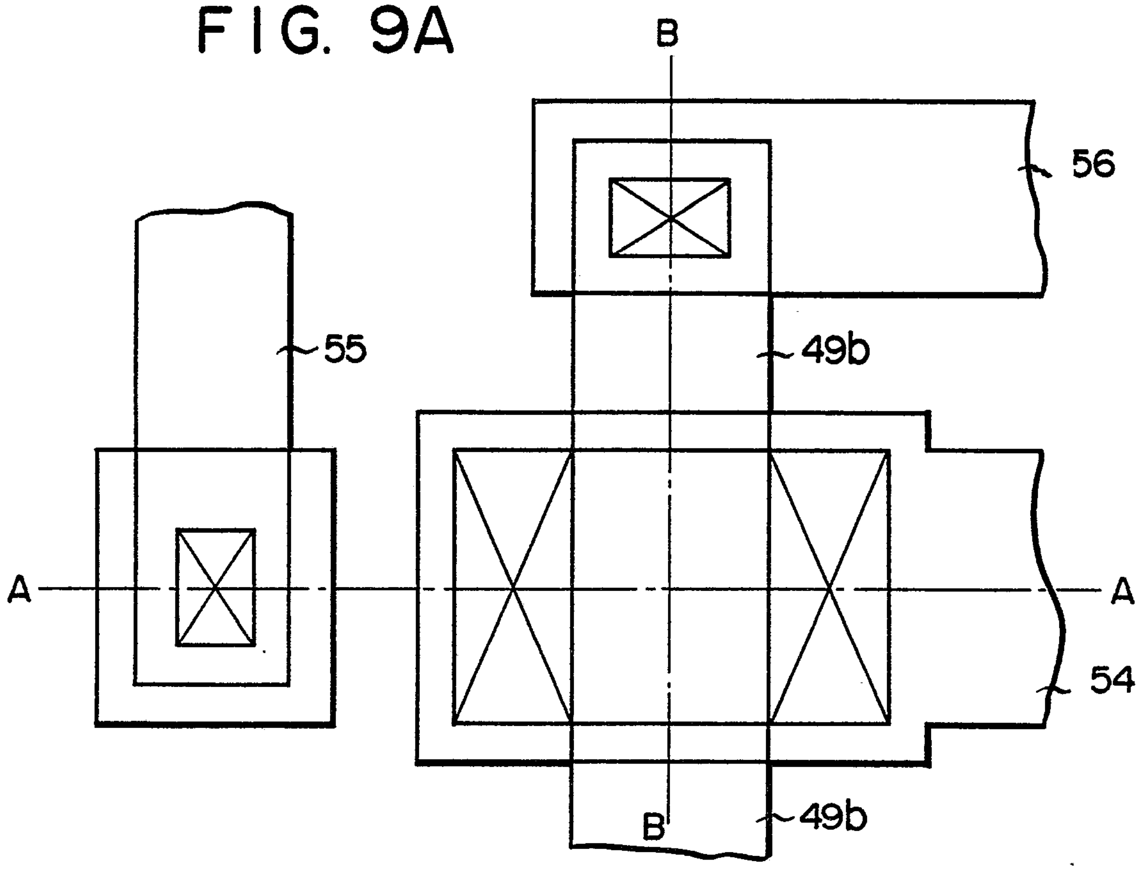


FIG. 9B

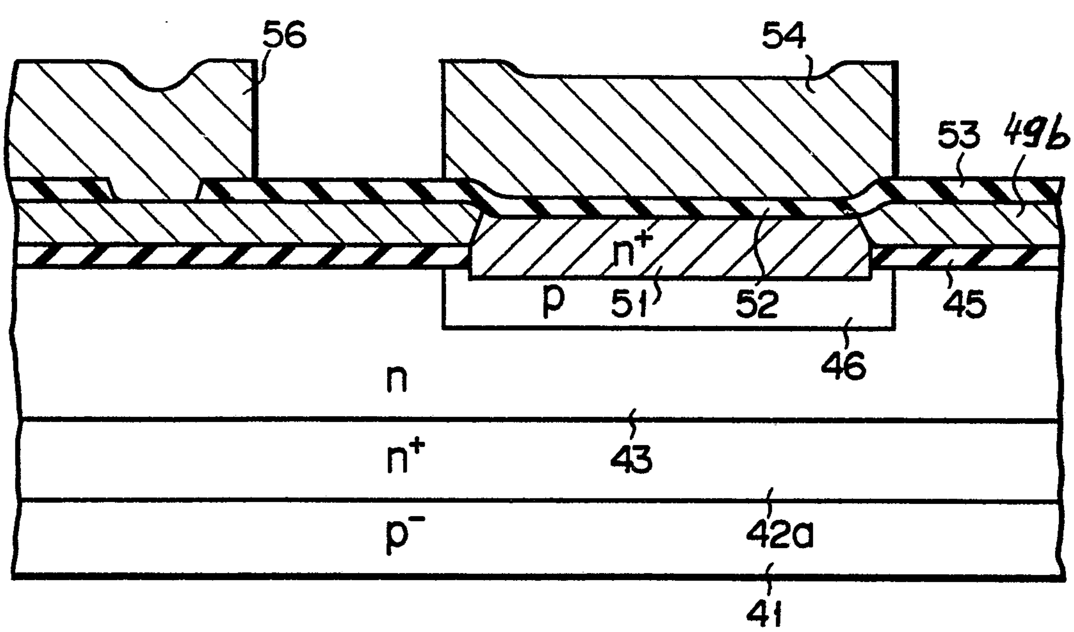

FIG. 10

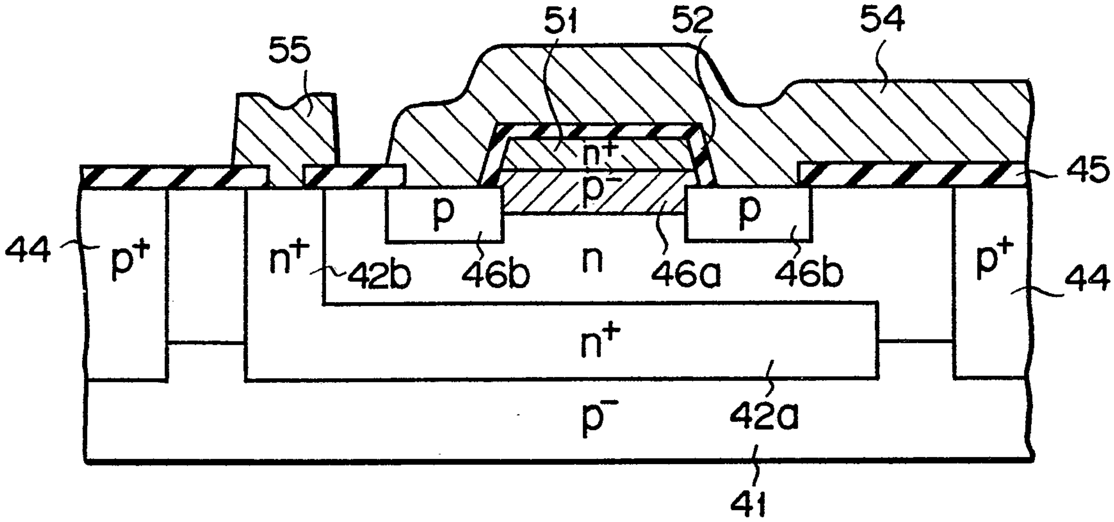


FIG. 11A

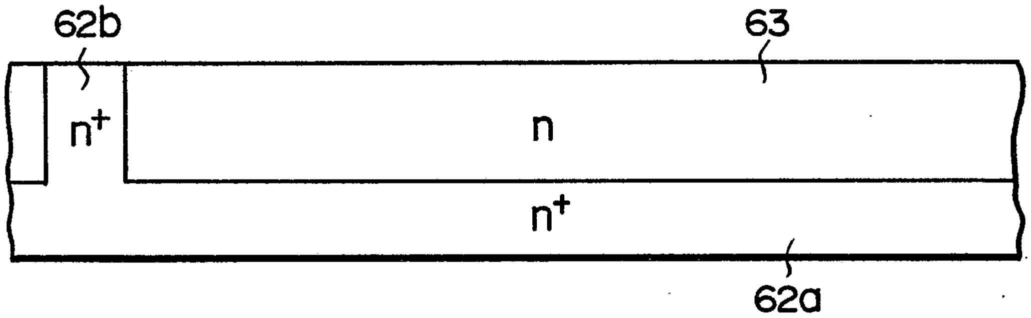


FIG. 11B

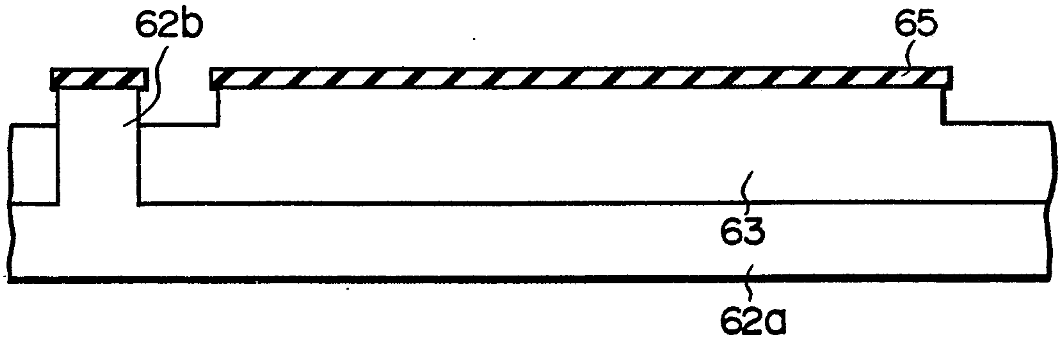

FIG. 11C

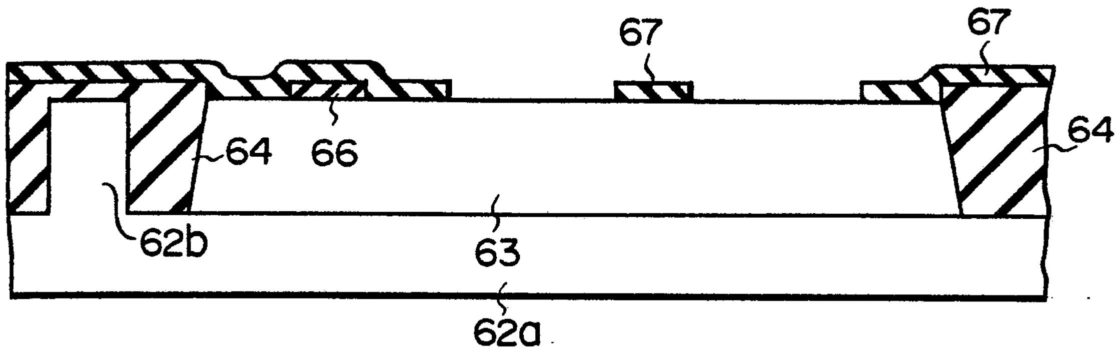


FIG. 11D

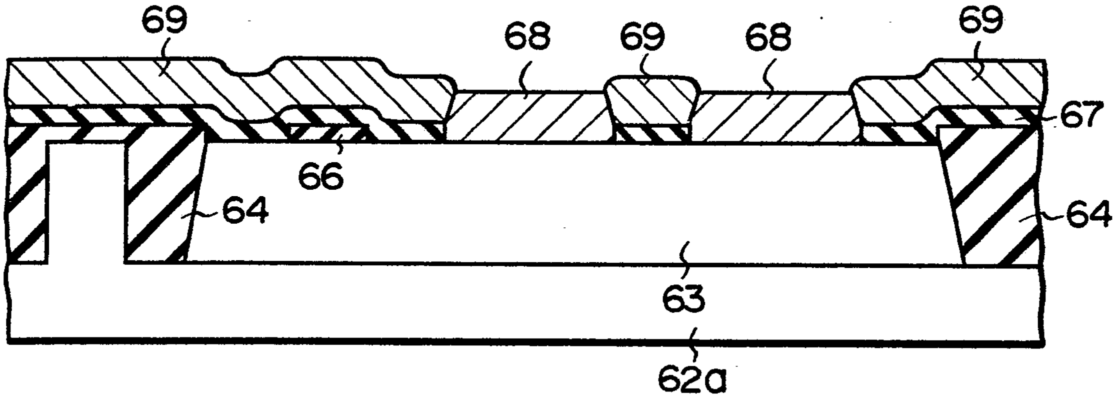


FIG. 11E

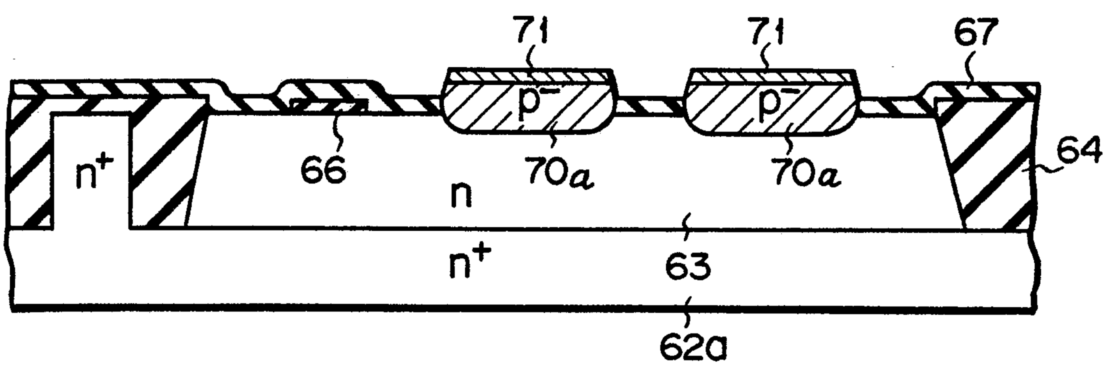

FIG. 11F

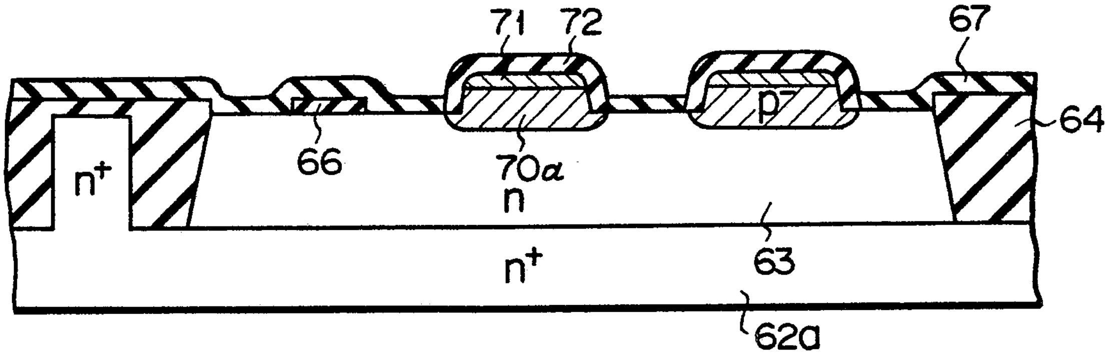


FIG. 11G

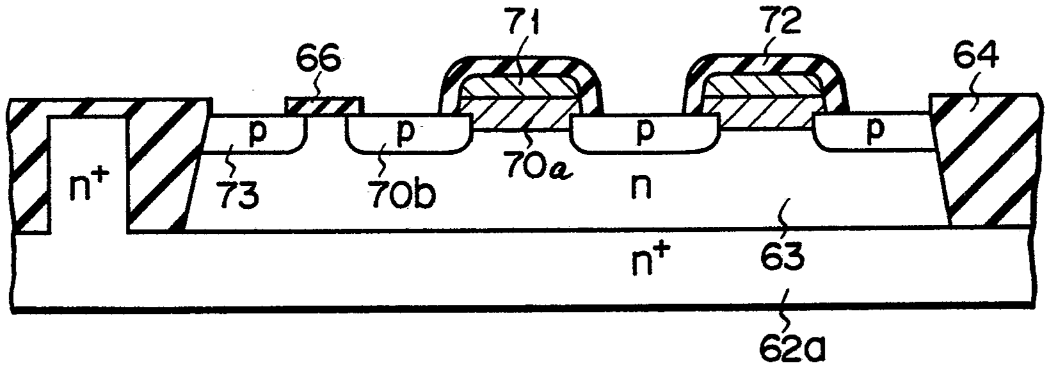


FIG. 11H

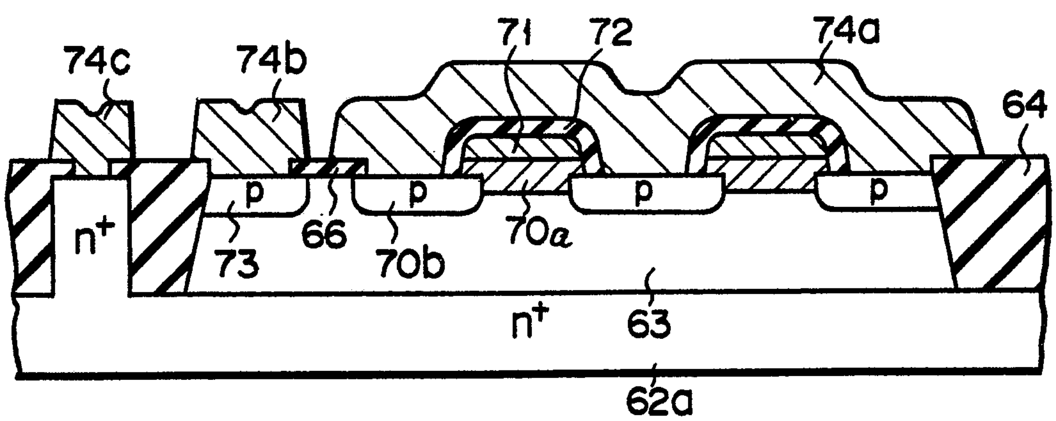

FIG. 12

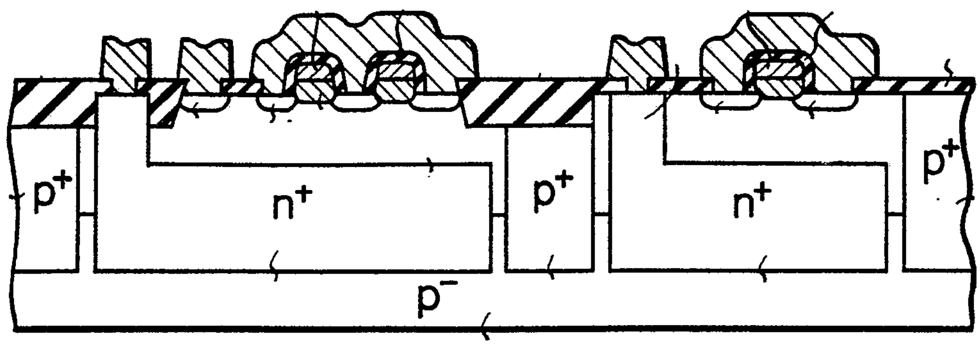


FIG. 13

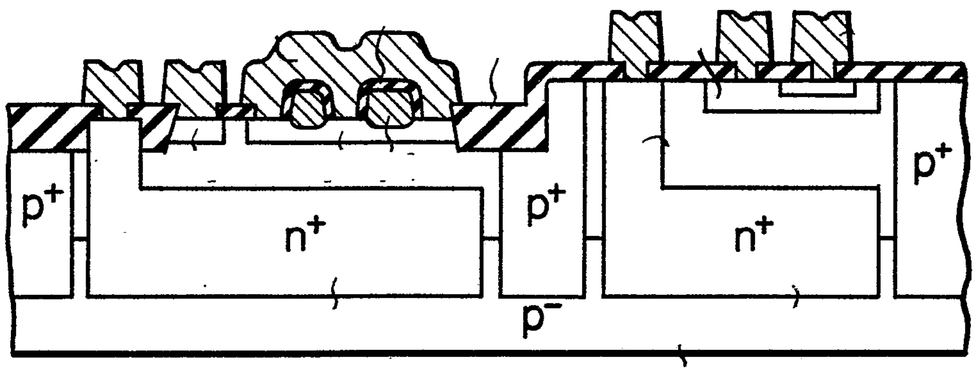


FIG. 14A

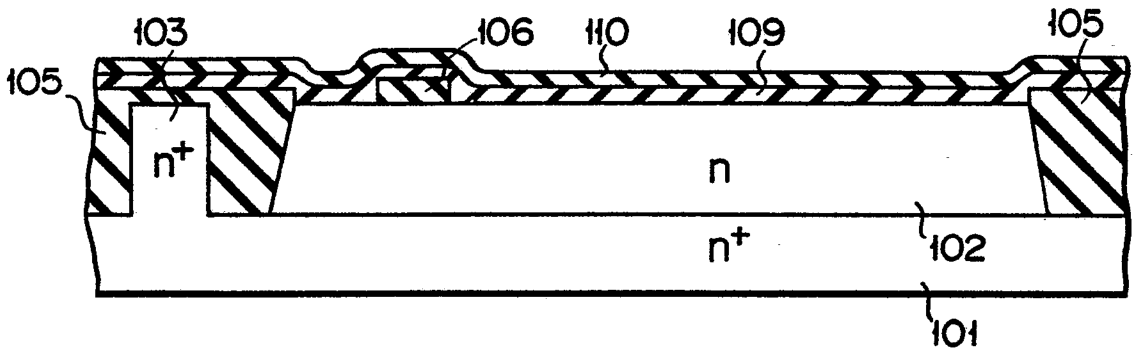


FIG. 14B

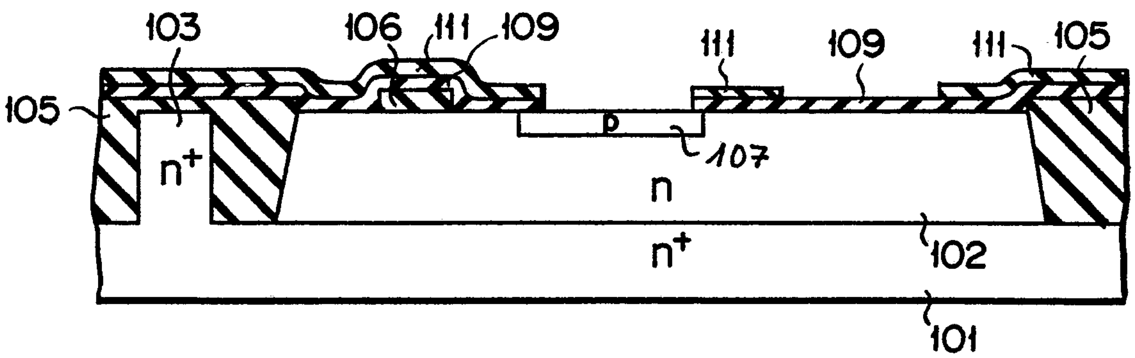

FIG. 14C

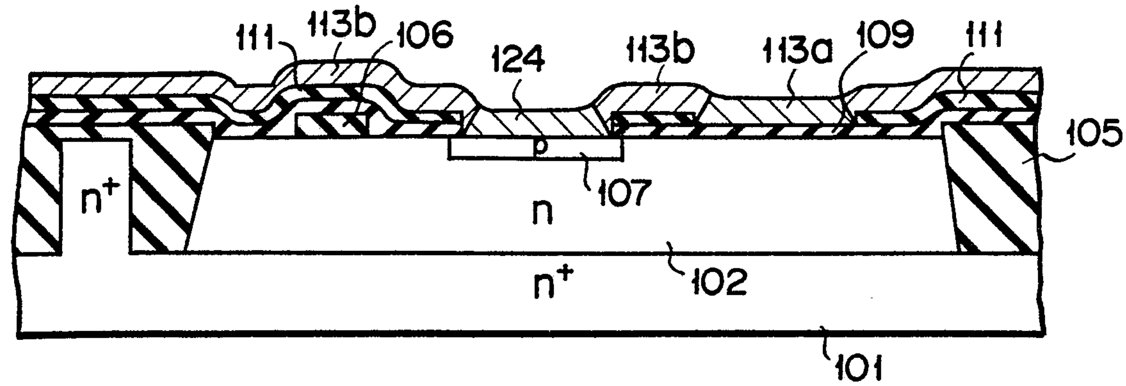


FIG. 14D

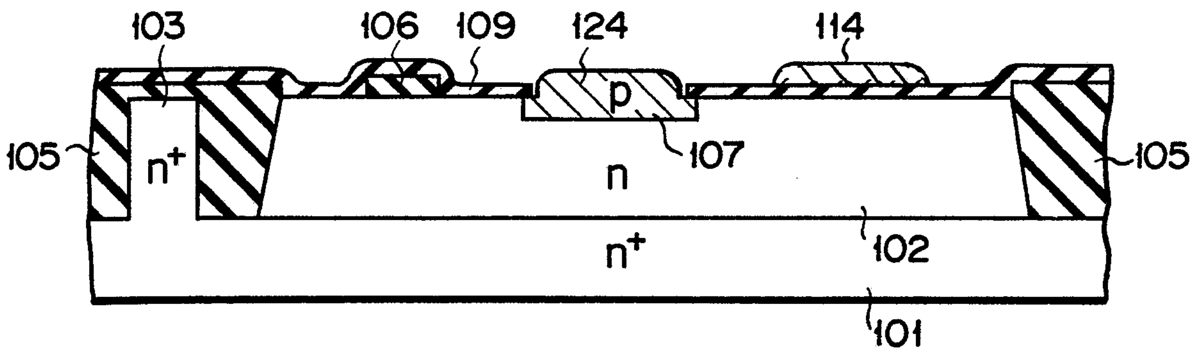


FIG. 14E

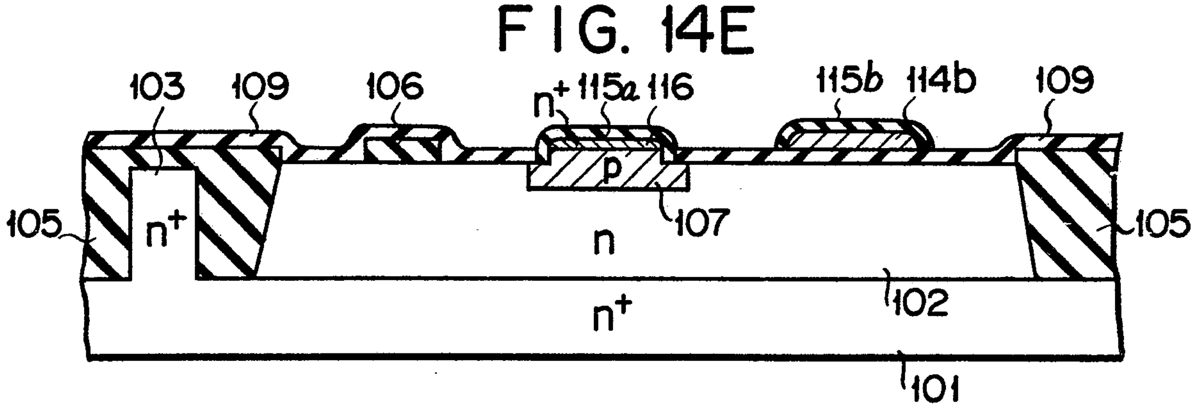


FIG. 14F

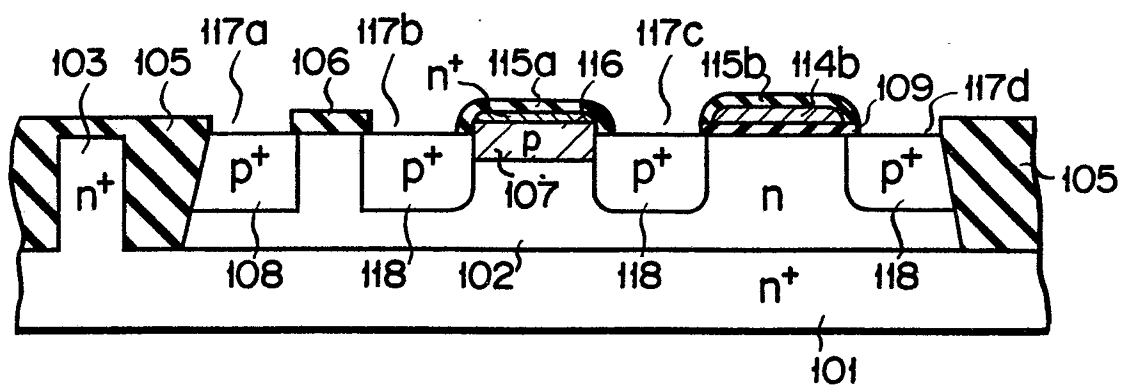

FIG. 14G

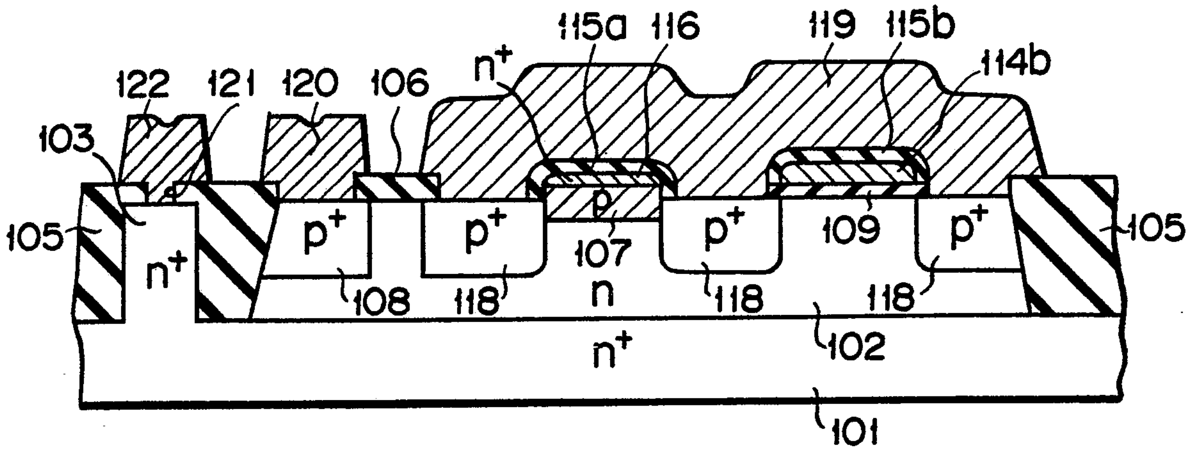


FIG. 15

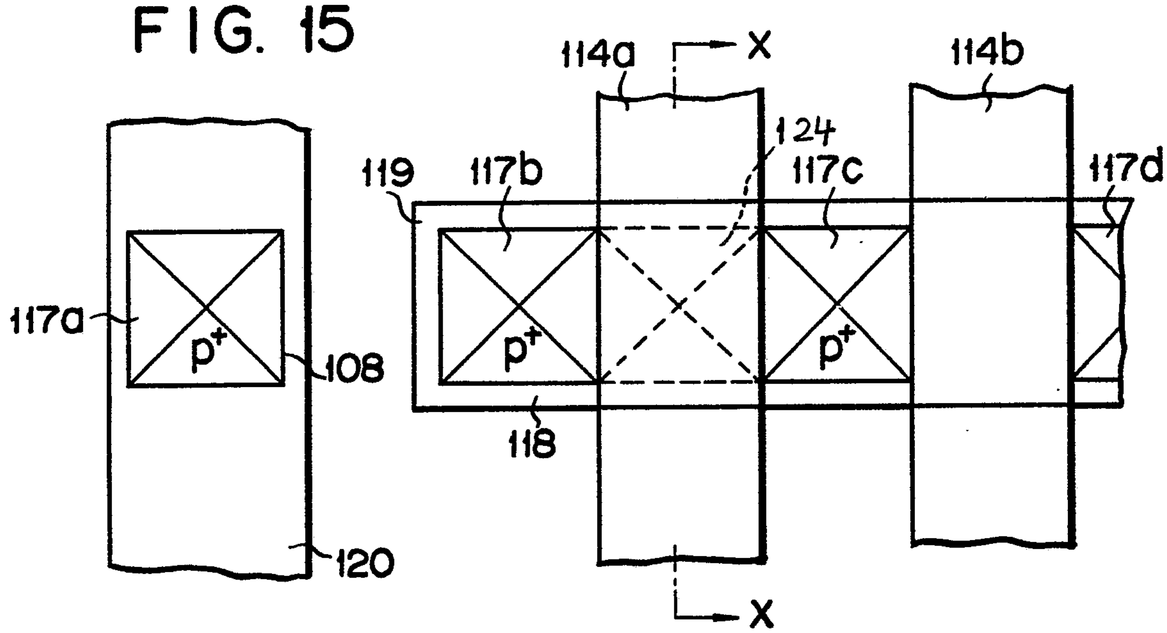


FIG. 16